(19)

**Europäisches Patentamt**

**European Patent Office**

**Office européen des brevets**

(11) **EP 3 145 009 B1**

(12) **FASCICULE DE BREVET EUROPEEN**

(45) Date de publication et mention
de la délivrance du brevet:
**13.06.2018 Bulletin 2018/24**

(51) Int Cl.:
*H01M 8/04298* (2016.01)   *H01M 8/0432* (2016.01)
*H01M 8/04537* (2016.01)   *H01M 8/04701* (2016.01)
*H01M 8/241* (2016.01)   *H01M 8/0267* (2016.01)
*H01M 8/0247* (2016.01)   *H01M 8/0265* (2016.01)
*H01M 8/0254* (2016.01)

(21) Numéro de dépôt: **16189557.8**

(22) Date de dépôt: **20.09.2016**

(54) **DÉTERMINATION D'UNE DISTRIBUTION SPATIALE DE LA RÉSISTANCE ÉLECTRIQUE DE CONTACT D'UNE CELLULE ÉLECTROCHIMIQUE**

BESTIMMUNG EINER RÄUMLICHEN VERTEILUNG DES ELEKTRISCHEN KONTAKTWIDERSTANDS EINER ELEKTROCHEMISCHEN ZELLE

DETERMINATION OF A SPATIAL DISTRIBUTION OF THE ELECTRICAL CONTACT RESISTANCE OF AN ELECTROCHEMICAL CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.09.2015 FR 1558894**

(43) Date de publication de la demande:
**22.03.2017 Bulletin 2017/12**

(73) Titulaire: **Commissariat à l'énergie atomique et aux énergies alternatives**
**75015 Paris (FR)**

(72) Inventeurs:
• **Poirot-Crouvezier, Jean-Philippe**
**38450 Saint Georges de Commiers (FR)**
• **Nandjou Dongmeza, Fredy-Intelligent**
**38100 Grenoble (FR)**
• **Robin, Christophe**
**38000 Grenoble (FR)**
• **Gerard, Mathias**
**38100 Grenoble (FR)**
• **Micoud, Fabrice**
**38500 La Buisse (FR)**

(74) Mandataire: **GIE Innovation Competence Group**
**310, avenue Berthelot**
**69372 Lyon Cedex 08 (FR)**

(56) Documents cités:
EP-A1- 2 924 793   WO-A1-2015/029983
FR-A1- 2 985 610   JP-A- 2005 293 902

• CHRISTOPHE ROBIN ET AL: "Development and experimental validation of a PEM fuel cell 2D-model to study heterogeneities effects along large-area cell surface", INTERNATIONAL JOURNAL OF HYDROGEN ENERGY., vol. 40, no. 32, 7 juillet 2015 (2015-07-07), pages 10211-10230, XP055237638, GB ISSN: 0360-3199, DOI: 10.1016/j.ijhydene.2015.05.178

• JABBOUR LARA ET AL: "Feasibility of in-plane GDL structuration: Impact on current density distribution in large-area Proton Exchange Membrane Fuel Cells", JOURNAL OF POWER SOURCES, vol. 299, 15 septembre 2015 (2015-09-15), pages 380-390, XP029297457, ISSN: 0378-7753, DOI: 10.1016/J.JPOWSOUR.2015.09.043

• STEFAN A FREUNBERGER ET AL: "Measuring the current distribution in PEFCs with sub-millimeter resolution", JOURNAL OF THE ELECTROCHEMICAL SOCIETY, PHILADELPHIA, US, US , vol. 153, no. 11 20 septembre 2006 (2006-09-20), pages A2158-A2165, XP002680728, DOI: 10.1149/1.2345591 Extrait de l'Internet: URL:http://jes.ecsdl.org/content/153/11/A2 158 [extrait le 2016-07-25]

EP 3 145 009 B1

**Description**

**DOMAINE TECHNIQUE**

Le domaine de l'invention est celui des réacteurs électrochimiques comportant un empilement de cellules électrochimiques, tels que les piles à combustible et les électrolyseurs, et plus précisément celui des procédés de détermination d'un paramètre représentatif de la résistance électrique de contact d'une cellule électrochimique permettant d'homogénéiser la distribution spatiale de température de la cellule en fonctionnement, ainsi que celui des procédés de réalisation d'une cellule ou d'un réacteur électrochimique.

**ÉTAT DE LA TECHNIQUE ANTÉRIEURE**

Un réacteur électrochimique tel qu'une pile à combustible ou un électrolyseur comporte habituellement un empilement de cellules électrochimiques qui comprennent chacune une anode et une cathode séparées électriquement l'une de l'autre par un électrolyte, dans laquelle a lieu une réaction électrochimique entre deux réactifs qui sont introduits de manière continue. Dans le cas d'une pile à hydrogène, le combustible (l'hydrogène) est apporté au contact de l'anode, et le comburant (l'oxygène), par exemple contenu dans de l'air, est amené au contact de la cathode. La réaction électrochimique est subdivisée en deux demi-réactions, une réaction d'oxydation et une réaction de réduction, qui ont lieu respectivement à l'interface anode/électrolyte et à l'interface cathode/électrolyte. Pour avoir lieu, la réaction électrochimique requiert la présence d'un conducteur ionique entre les deux électrodes, à savoir l'électrolyte éventuellement sous forme d'une membrane polymère, et un conducteur électronique formé par le circuit électrique externe. L'empilement de cellules est ainsi le lieu de la réaction électrochimique, ce qui nécessite d'apporter les espèces réactives, d'évacuer les produits et les espèces non réactives ainsi que la chaleur produite.

Les cellules sont habituellement séparées les unes des autres par des plaques bipolaires qui assurent l'interconnexion électrique des cellules. Les plaques comportent un circuit de distribution du carburant formé sur une face anodique et un circuit de distribution du comburant formé sur une face cathodique opposée à la face anodique. Chaque circuit de distribution prend souvent la forme d'un réseau de canaux agencés par exemple en parallèle ou en serpentin, adaptés à amener l'espèce réactive de manière homogène à l'électrode correspondante. Les plaques bipolaires peuvent également comporter un circuit de refroidissement formé d'un réseau de conduits internes qui assurent l'écoulement d'un fluide caloporteur permettant d'évacuer la chaleur produite localement lors de la réaction par la cellule.

Chaque électrode est habituellement formée d'une couche de diffusion et d'une couche active. La couche de diffusion est située entre la couche active et la plaque bipolaire correspondante. Elle est réalisée en un matériau poreux permettant la diffusion des espèces réactives gazeuses jusqu'à la couche active ainsi que la diffusion des réactifs issus de la réaction électrochimique. La couche active, située entre la membrane électrolytique et la couche de diffusion, est le lieu de la réaction électrochimique. Elle comporte généralement un conducteur électronique (par exemple du carbone), un conducteur protonique (l'électrolyte) et un catalyseur, par exemple des particules de platine. Elle peut être formée d'un mélange de poudre de carbone platinée, de particules de PTFE et d'électrolyte polymère (par exemple du Nafion), disposé sur un tissu de carbone correspondant à la couche de diffusion.

L'empilement de cellules électrochimiques est habituellement disposé entre deux plaques terminales (*end-plates*, en anglais) qui appliquent une force de serrage, ou effort mécanique, sur l'empilement via des éléments de serrage tels que des boulons tirants, cet effort permettant d'obtenir une étanchéité adéquate en bordure des cellules électrochimiques d'une part, et un contact électrique suffisant entre les cellules d'autre part. L'article de Wang et al. intitulé Experimental study on clamping pressure distribution in PEM fuel cells, Journal of Power Sources, 179 (2008) 305-309 montre que la performance d'une pile à combustible est meilleure lorsque la force de serrage induit au sein des cellules une contrainte mécanique en compression répartie spatialement de manière homogène. Pour cela, l'article de Yu et al. intitulé Composite endplates with pre-curvature for PEMFC (polymer electrolyte membrane fuel cell), Composite Structures 92 (2010) 1498-1503 décrit des plaques terminales initialement convexes de sorte que, une fois assemblées à l'empilement, elles présentent une courbure sensiblement nulle, entraînant ainsi la répartition sensiblement uniforme de la force de serrage.

Par ailleurs, on cherche à préserver la durée de vie des cellules électrochimiques, par exemple en uniformisant la distribution spatiale de la densité de courant produit par la cellule en fonctionnement. En effet, les inhomogénéités spatiales de densité de courant entraînent des inhomogénéités spatiales de température de la cellule, qui peuvent conduire, d'une part, à augmenter la cinétique des réactions de dégradations des différents éléments de la cellule, et d'autre part, à générer des contraintes mécaniques d'origine thermique susceptibles de fragiliser la tenue mécanique des éléments de la cellule.

A titre illustratif, le document FR2976732 décrit une cellule électrochimique réalisée de manière à obtenir un échauffement local homogène au sein de la cellule en fonctionnement. L'échauffement dépend de la densité de courant électrique en chaque point de la cellule qui est elle-même fonction de la pression partielle d'espèce réactive. En effet, considérant ici le côté cathodique de la cellule, la quantité d'oxygène contenu dans le gaz circulant dans le circuit de distribution diminue progressivement à mesure que l'oxygène est consommé par la cellule, ce qui entraîne une variation spatiale de la densité de courant électrique produit par la cellule, et donc une variation spatiale de l'échauffement de la cellule. Pour éviter cette inhomogénéité spatiale de l'échauffement de la cellule, la conductivité électrique entre la plaque bipolaire amenant l'oxygène et la cellule est ajustée localement de manière à compenser la diminution de la pression partielle d'oxygène.

## EXPOSÉ DE L'INVENTION

L'invention a pour objectif de remédier au moins en partie aux inconvénients de l'art antérieur, et plus particulièrement de proposer un procédé de détermination de la distribution spatiale d'un paramètre représentatif d'une résistance électrique de contact d'une cellule électrochimique permettant notamment d'homogénéiser la température locale de la cellule électrochimique en fonctionnement et ainsi de préserver la durée de vie de cette dernière.

L'invention propose à cet effet un procédé de détermination d'une distribution spatiale d'un paramètre d'intérêt représentatif d'une résistance de contact entre une plaque bipolaire et une électrode adjacente d'une cellule électrochimique, ladite cellule comportant deux électrodes séparées l'une de l'autre par un électrolyte et disposées entre des plaques bipolaires adaptées à amener des espèces réactives aux électrodes et à évacuer de la chaleur produite par la cellule en fonctionnement, comprenant les étapes suivantes :

i) fourniture d'une cellule électrochimique, au sein de laquelle le paramètre d'intérêt est réparti selon une distribution spatiale initiale, pour laquelle la distribution spatiale d'une température au sein de la cellule électrochimique en fonctionnement présente au moins une valeur locale supérieure ou égale à une valeur locale maximale prédéterminée ;

ii) définition d'une distribution spatiale d'une température de consigne au sein de la cellule en fonctionnement, telle que les valeurs locales de température sont inférieures à des valeurs locales maximales prédéterminées ;

iii) mesure d'une distribution spatiale d'une première grandeur thermique représentative de l'évacuation locale de la chaleur au sein de ladite cellule électrochimique en fonctionnement ;

iv) estimation d'une distribution spatiale d'une seconde grandeur thermique représentative de la production locale de chaleur au sein de ladite cellule électrochimique en fonctionnement, en fonction de ladite distribution spatiale de la température de consigne et de ladite distribution spatiale de la première grandeur thermique, de sorte que la distribution spatiale de température de ladite cellule électrochimique en fonctionnement, dont la première grandeur thermique présente ladite distribution spatiale mesurée et la seconde grandeur thermique présente ladite distribution spatiale estimée, soit sensiblement égale à celle de la température de consigne ;

v) détermination une distribution spatiale du paramètre d'intérêt en fonction de la distribution spatiale estimée de la seconde grandeur thermique,

et dans lequel l'étape d'estimation d'une distribution spatiale de la seconde grandeur thermique comporte

- une phase de réalisation d'un maillage d'un circuit de refroidissement d'au moins une plaque bipolaire de la cellule électrochimique dans lequel est destiné à s'écouler un fluide caloporteur;

- une phase de simulation numérique par ordinateur de la seconde grandeur thermique, sur ledit maillage, par résolution d'un modèle numérique discret exprimant la seconde grandeur thermique en fonction de la température locale et de la première grandeur thermique.

On obtient ainsi une distribution spatiale du paramètre d'intérêt, dont la prise en compte dans la cellule électrochimique considérée, permet à celle-ci, en fonctionnement, de présenter une distribution spatiale de température correspondant sensiblement à celle de la température de consigne. On évite ainsi que la cellule électrochimique en fonctionnement présente alors des zones dans lesquelles la température serait localement supérieure à des valeurs locales maximales prédéterminées.

La fourniture de la cellule électrochimique peut comporter une phase de réalisation expérimentale ou de modélisation numérique d'une cellule électrochimique, une phase de mesure de la distribution spatiale de la température au sein de la cellule électrochimique en fonctionnement, puis une phase de comparaison de la distribution spatiale mesurée de la température vis-à-vis d'une distribution spatiale prédéterminée d'une température maximale. Les valeurs locales de cette distribution spatiale de température maximale sont dites valeurs locales maximales prédéterminées. Lorsqu'au moins une valeur locale de la température mesurée est supérieure ou égale à une valeur locale maximale prédéterminée correspondante, c'est-à-dire pour la même position au sein de la distribution spatiale, la cellule électrochimique est alors fournie, c'est-à-dire considérée, pour les étapes suivantes du procédé de détermination.

La définition de la température de consigne peut être effectuée de sorte que les valeurs locales de température sont inférieures aux valeurs locales maximales correspondantes. La température de consigne peut présenter des valeurs locales sensiblement constantes, voire un gradient local de température sensiblement constant. Elle peut présenter des valeurs locales non constantes au sein de la distribution spatiale, qui restent inférieures à ces valeurs maximales prédéterminées. Elle peut également présenter un gradient local non constant au sein de la distribution spatiale, qui reste inférieur à des valeurs maximales prédéterminées.

La mesure de la distribution spatiale de la première grandeur thermique peut être une mesure expérimentale effectuée sur la cellule électrochimique considérée préalablement fabriquée, ou une mesure numérique effectuée sur un modèle numérique de la cellule électrochimique considérée. La première grandeur thermique peut être le débit local de fluide caloporteur parcourant un circuit de refroidissement d'une plaque bipolaire.

L'estimation de la distribution spatiale de la seconde grandeur thermique comporte :

- une phase de réalisation d'un maillage, par exemple bidimensionnel ou tridimensionnel, d'un circuit de refroidissement d'au moins une plaque bipolaire de la cellule électrochimique dans lequel est destiné à s'écouler un fluide caloporteur, et
- une phase de simulation numérique par ordinateur de la seconde grandeur thermique, sur ledit maillage, par résolution d'un modèle numérique discret exprimant la seconde grandeur thermique en fonction de la température locale et de la première grandeur thermique.

Dans ce cas, le modèle numérique prend en compte la distribution spatiale de la température de consigne et la distribution spatiale préalablement mesurée de la première grandeur thermique. Le modèle numérique discret, dit électrochimique, peut être une relation exprimant un paramètre représentatif de la production locale de chaleur, par exemple le flux local de chaleur, en fonction de la température locale et d'un paramètre représentatif de l'évacuation locale de chaleur, par exemple le débit local du fluide caloporteur.

Ainsi, la cellule électrochimique, dont la distribution spatiale du paramètre d'intérêt a été obtenue par le procédé de détermination, présente en fonctionnement une distribution spatiale de température sensiblement égale à celle de la température de consigne. On évite ainsi la génération de nouveaux points chauds ou nouvelles inhomogénéités de température, non voulus, qui pourraient apparaître si la distribution spatiale du paramètre d'intérêt était déterminée par une approche essentiellement thermique, c'est-à-dire sur la base d'une comparaison de la température réelle qui présente des points chauds ou inhomogénéités, et de la température de consigne.

De préférence, les plaques bipolaires sont formées de deux tôles accolées l'une à l'autre, chaque tôle comportant des bossages formant au niveau d'une face dite externe un circuit de distribution d'une espèce réactive, les bossages des tôles formant ensemble, au niveau de faces dites internes opposées aux faces externes, un circuit de refroidissement comportant des canaux de refroidissement qui communiquent fluidiquement entre eux entre une entrée et une sortie du circuit de refroidissement. Les faces externes des tôles sont orientées vers une électrode de cellule électrochimique. Les canaux de refroidissement communiquent fluidiquement entre eux dans le sens où, entre l'entrée et la sortie du circuit de refroidissement, ils forment un réseau fluidique bidimensionnel, c'est-à-dire non linéaire.

De préférence, l'étape de détermination de la distribution spatiale du paramètre d'intérêt est effectuée en fonction, également, d'une valeur prédéterminée d'un paramètre représentatif de la puissance électrique globale de la cellule électrochimique. Le paramètre peut être la puissance électrique globale, à savoir le produit de la tension et de la densité de courant mesurées aux bornes de la cellule, voire le rendement de celle-ci, par exemple la tension de la cellule pour une densité de courant donnée. Il est alors possible de gérer à la fois la température locale au sein de la cellule électrochimique, dans le but d'en optimiser la durée de vie, tout en maintenant une puissance électrique voulue.

Le paramètre d'intérêt est de préférence la résistance électrique de contact de la cellule électrochimique, la première grandeur thermique est une température locale effective mesurée au sein de la cellule en fonctionnement, et la seconde grandeur thermique est une grandeur représentative d'un écart local entre la température effective et la température de consigne.

De préférence, l'étape v) comporte :

- une sous-étape de calcul d'une distribution spatiale d'un coefficient correcteur à partir de la distribution spatiale de la seconde grandeur thermique ;
- une sous-étape dans laquelle on détermine la distribution spatiale du paramètre d'intérêt par corrélation de la distribution spatiale initiale du paramètre d'intérêt avec la distribution spatiale du coefficient correcteur.

Alternativement, l'étape v) peut comporter :

- une sous-étape dans laquelle on identifie au moins une zone de la cellule où la seconde grandeur thermique présente une valeur locale estimée supérieure à une valeur seuil prédéterminée ;

- une sous-étape dans laquelle on détermine la distribution spatiale du paramètre d'intérêt par modification de la distribution spatiale initiale dans la zone identifiée, en fonction de la valeur locale estimée de la seconde grandeur thermique dans cette zone.

De préférence, le paramètre d'intérêt est la résistance électrique de contact de la cellule électrochimique, la première grandeur thermique est représentative de l'évacuation locale de la chaleur produite par la cellule en fonctionnement, et la seconde grandeur thermique est représentative de la production locale de chaleur par la cellule en fonctionnement.

La première grandeur thermique peut être le débit local effectif mesuré d'un fluide caloporteur circulant dans un circuit de refroidissement d'une plaque bipolaire de la cellule, et la seconde grandeur thermique peut être le flux local de chaleur produite par la cellule en fonctionnement.

De préférence, l'étape v) comporte :

- une première sous-étape dans laquelle on estime la distribution spatiale de la densité d'un signal électrique produit par la cellule en fonctionnement, à partir de la distribution spatiale estimée du flux de chaleur produite, et
- une deuxième sous-étape dans laquelle on détermine la distribution spatiale du paramètre d'intérêt à partir de la densité locale du signal électrique.

L'invention porte également sur un procédé de réalisation d'une cellule électrochimique, comportant les étapes dans lesquelles :

- on considère une cellule électrochimique de référence comportant deux électrodes séparées l'une de l'autre par un électrolyte et disposées entre des plaques bipolaires adaptées à amener des espèces réactives aux électrodes et à évacuer de la chaleur produite par la cellule en fonctionnement, les plaques bipolaires présentant une distribution spatiale initiale d'épaisseur, la cellule présentant un paramètre d'intérêt représentatif de la résistance électrique de contact réparti spatialement selon une distribution initiale ;
- on détermine, par le procédé de détermination selon l'une quelconque des caractéristiques précédentes, une distribution spatiale du paramètre d'intérêt ;
- on réalise ladite cellule à partir de la cellule de référence, de sorte que le paramètre d'intérêt présente la distribution spatiale déterminée.

Par à partir de, on entend que la cellule électrochimique réalisée présente les mêmes propriétés électrochimiques que celles de la cellule de référence, hormis le paramètre d'intérêt qui est réparti selon la distribution spatiale déterminée. La cellule électrochimique réalisée peut être la cellule de référence dans laquelle la distribution spatiale initiale du paramètre d'intérêt a été modifiée pour être sensiblement égale à la distribution spatiale déterminée.

De préférence, on détermine une distribution spatiale d'épaisseur d'au moins l'une des plaques bipolaires en fonction de la distribution spatiale déterminée.

De préférence, ladite plaque bipolaire présente localement une épaisseur inférieure ou supérieure à une épaisseur nominale de la plaque sensiblement égale à l'épaisseur initiale, dans des zones préalablement identifiées à partir de ladite distribution spatiale déterminée de la résistance électrique de contact.

L'invention porte également sur un procédé de réalisation d'un réacteur électrochimique, comportant les étapes dans lesquelles :

- on considère un réacteur électrochimique de référence comportant un empilement de cellules électrochimiques enserrées et comprimées entre deux plaques terminales, chaque cellule comprenant deux électrodes séparées l'une de l'autre par un électrolyte et disposées entre des plaques bipolaires adaptées à amener des espèces réactives aux électrodes et à évacuer de la chaleur produite par la cellule en fonctionnement, et présentant un paramètre d'intérêt représentatif de la résistance électrique de contact réparti spatialement selon une distribution initiale ;
- on détermine, par le procédé de détermination selon l'une quelconque des caractéristiques précédentes, une distribution spatiale du paramètre d'intérêt pour au moins l'une des cellules ;
- on réalise ledit réacteur électrochimique à partir du réacteur de référence, de sorte que le paramètre d'intérêt présente la distribution spatiale déterminée.

De préférence, on détermine une distribution spatiale d'épaisseur d'au moins l'une des plaques terminales, et/ou une distribution spatiale d'épaisseur d'au moins une plaque insérée entre deux cellules adjacentes dudit empilement, en fonction de la distribution spatiale déterminée.

L'invention porte également sur une cellule électrochimique comportant deux électrodes séparées l'une de l'autre par un électrolyte et disposées entre des plaques bipolaires adaptées à amener des espèces réactives aux électrodes et à évacuer de la chaleur produite par la cellule en fonctionnement, caractérisée en ce qu'au moins l'une des plaques bipolaires présente une épaisseur locale inférieure ou supérieure à une épaisseur nominale de la plaque, dans au moins une partie de sa surface.

L'invention porte également sur un réacteur électrochimique comportant un empilement de cellules électrochimiques enserrées et comprimées entre deux plaques terminales, chaque cellule comprenant deux électrodes séparées l'une de l'autre par un électrolyte et disposées entre des plaques bipolaires adaptées à amener des espèces réactives aux électrodes et à évacuer de la chaleur produite par la cellule en fonctionnement, caractérisée en ce qu'au moins l'une des plaques terminales présente une face en contact avec l'empilement de cellules dont la surface est localement structurée de manière à présenter des protubérances ou des échancrures dans au moins une partie de sa surface, et/ou en ce qu'elle comporte une plaque insérée entre deux cellules adjacentes dont au moins l'une de ses faces en contact avec les cellules présente une surface localement structurée de manière présenter des protubérances ou des échancrures dans au moins une partie de sa surface.

L'invention porte également sur un support d'enregistrement, comportant des instructions pour la mise en oeuvre du procédé de détermination selon l'une quelconque des caractéristiques précédentes, ces instructions étant aptes à être exécutées par un processeur.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

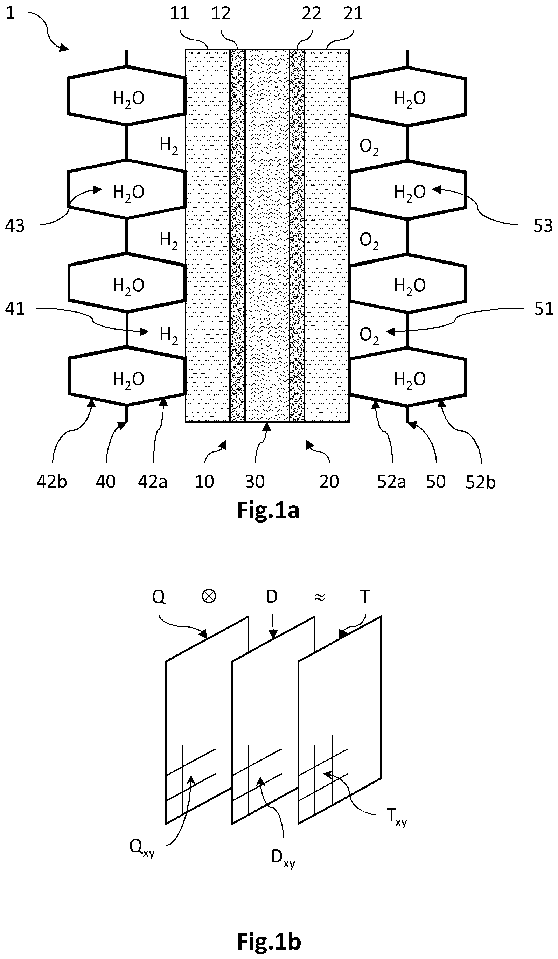

la figure la est une représentation schématique en coupe d'un exemple de cellule électrochimique, et la figure 1b est une représentation schématique illustrant la relation de corrélation entre la distribution spatiale de la production de chaleur Q et la distribution spatiale d'évacuation D de chaleur dont résulte la distribution spatiale de température T de la cellule électrochimique en fonctionnement ;

la figure 2 est un organigramme d'un procédé de détermination de la distribution spatiale de la résistance électrique de contact de la cellule électrochimique selon un premier mode de réalisation ;

la figure 3 illustre des exemples de courbes de polarisation qui montrent l'évolution de la tension électrique de la cellule en fonction de la densité locale du courant électrique, pour différentes valeurs de la résistance électrique locale ;

la figure 4 est un organigramme d'un procédé de détermination de la distribution spatiale de la résistance électrique de contact de la cellule électrochimique selon un deuxième mode de réalisation ;

la figure 5 est un exemple de maillage du circuit de refroidissement où chaque maille comporte un terme de production locale de chaleur $Q_{i,j}^e$, un terme d'évacuation locale de chaleur $D_{i,j}^r$, et une température locale $T_{i,j}^c$ ;

les figures 6a et 6b illustrent de manière schématique et partielle une plaque bipolaire située entre deux cellules électrochimiques adjacentes, la plaque bipolaire présentant une épaisseur sensiblement constante spatialement (fig.6a) ou qui varie localement (fig.6b) ;

la figure 7a illustre des exemples de relation entre la résistance électrique d'une cellule électrochimique en fonction de la contrainte de compression subie par la cellule, pour différents types de couche de diffusion ; et la figure 7b illustre des exemples de relation entre l'épaisseur d'une couche de diffusion de cellule électrochimique en fonction de la contrainte de compression subie par la cellule, pour différents types de couche de diffusion ;

la figure 8 illustre de manière schématique et partielle un réacteur électrochimique comportant un empilement de cellules comprimé entre deux plaques bipolaires à surface structurée et comportant un insert à surface structurée.

## EXPOSÉ DÉTAILLÉ DE MODES DE RÉALISATION PARTICULIERS

Sur les figures et dans la suite de la description, les mêmes références représentent des éléments identiques ou similaires. De plus, les différents éléments ne sont pas représentés à l'échelle, de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

On décrira différents modes de réalisation et variante en référence à une pile à combustible, et en particulier à une pile à hydrogène de type PEM (pour *Proton Exchange Membrane,* en anglais) dont la cathode est alimentée en oxygène et l'anode en hydrogène. L'invention s'applique cependant à tout type de pile à combustible, en particulier à celles fonctionnant à basse température, c'est-à-dire à une température inférieure à 250°C, ainsi qu'aux électrolyseurs électrochimiques.

La figure la illustre de manière partielle et schématique un exemple de cellule électrochimique 1 appartenant à un empilement de cellules d'une pile à combustible de type PEM. La cellule 1 comporte une anode 10 et une cathode 20 séparées l'une de l'autre par un électrolyte comprenant ici une membrane polymère 30, les électrodes 10, 20 étant disposées entre deux plaques bipolaires 40, 50 adaptées à amener des espèces réactives aux électrodes et à évacuer la chaleur produite lors de la réaction électrochimique.

Les plaques bipolaires comportent un circuit de distribution d'hydrogène 41 situé sur une face anodique et un circuit de distribution d'oxygène 51 situé sur une face cathodique. Elles sont ici formées de deux tôles métalliques 42a, 42b ; 52a, 52b, assemblées l'une à l'autre, et sont embouties de manière à former les circuits de distribution. L'agencement des bossages permet de réaliser également un circuit de refroidissement 43, 53 à l'intérieur des plaques assurant l'écoulement d'un fluide caloporteur sans que celui-ci ne vienne au contact des électrodes. D'autres technologies de plaque bipolaire peuvent être utilisées, par exemple les plaques réalisées en matériau composite chargé par exemple de graphite, où les bossages sont réalisés par moulage.

Comme mentionné précédemment, chaque électrode 10, 20 comporte une couche de diffusion 11, 21 (GDL, pour *Gas Diffusion Layer,* en anglais) disposée au contact de l'une des plaques bipolaires 40, 50 et une couche active 12, 22 située entre la membrane 30 et la couche de diffusion 11, 21. Les couches de diffusion 11, 21 sont réalisées en matériau poreux autorisant la diffusion des espèces réactives à partir du circuit de distribution des plaques bipolaires jusqu'aux couches actives, ainsi que la diffusion des produits issus de la réaction électrochimique jusqu'au même circuit de distribution. Les couches actives 12, 22 sont le lieu des réactions électrochimiques. Elles comportent des matériaux adaptés à permettre les réactions d'oxydation et de réduction aux interfaces respectives de l'anode et la cathode avec la membrane. Plus précisément, elles comportent chacune un ionomère assurant la conductivité protonique, par exemple du Nafion, un catalyseur pour générer la réaction électrochimique, par exemple du platine, et un support électriquement conducteur, par exemple une matrice carbonée.

La cellule électrochimique présente une résistance électrique R qui dépend notamment de la somme des résistances électriques ohmiques des différents éléments de la cellule (plaques bipolaires $R_{PB}$, membrane $R_m$, électrodes $R_{GDL}$) ainsi que de la résistance de contact Rc entre chaque plaque bipolaire et la couche active de l'électrode adjacente. La résistance de contact Rc dépend notamment de la surface de contact entre la plaque bipolaire et la couche de diffusion, ainsi que de la contrainte en compression issue d'une force de serrage appliquée à la cellule et notamment subie par la couche de diffusion. La résistance de contact comporte ainsi un terme lié à l'interface entre la plaque bipolaire et la couche de diffusion et un terme lié à la résistance électrique propre de la couche de diffusion. Elle peut être mesurée sur des échantillons des matériaux constituant la cellule, afin de connaître son évolution en fonction de l'effort mécanique appliqué au niveau du contact.

La figure 1b représente schématiquement la distribution spatiale de température T de la cellule électrochimique comme résultant d'une relation de corrélation entre la distribution spatiale d'un terme source de production de chaleur, autrement dit d'une grandeur représentative de la production de chaleur par la cellule, par exemple le flux de chaleur produite Q, et la distribution spatiale d'une grandeur représentative de l'évacuation de la chaleur produite, par exemple le débit massique D du fluide caloporteur dans le circuit de refroidissement.

Ainsi, contrairement à l'enseignement de la demande FR2976732 cité précédemment, homogénéiser la distribution de production de chaleur Q et donc celle de l'échauffement de la cellule ne peut suffire à obtenir l'homogénéisation de la distribution de température T effective de la cellule. En effet, il importe de tenir compte à la fois de la présence d'éventuelles inhomogénéités locales dans le terme Q de production de chaleur ainsi que de la présence d'éventuelles inhomogénéités locales dans le terme D d'évacuation de chaleur.

La production locale de chaleur, ou plus précisément le flux local de chaleur produite Q, est directement proportionnelle à la production locale d'énergie électrique, ou plus précisément à la densité locale de courant I, comme l'exprime la relation entre les distributions spatiales respectives :

$$Q_{x,y} = I_{x,y} \left( \Delta H/2F - U_{x,y} \right) \qquad\qquad (1)$$

où $\Delta H$ est l'enthalpie de la réaction électrochimique, F la constante de Faraday, et $U_{x,y}$ la distribution spatiale de la tension locale de la cellule, l'enthalpie et la tension pouvant être considérées comme quasiment homogènes en tout point de la cellule. Ainsi, la production de chaleur est impactée par toute inhomogénéité qui provient de paramètres fluidiques (dimensionnement des circuits de distribution des espèces réactives...), électrochimiques (propriétés locales des électrodes et de la membrane...), mais également électriques (résistances électriques des différents éléments de la cellule, par exemple résistivités des matériaux et résistances de contact entre les éléments de la cellule...), qui tous influent sur la distribution de densité de courant.

L'évacuation de chaleur par l'écoulement du fluide caloporteur peut également présenter des inhomogénéités locales qui proviennent notamment de pertes de charge singulières dans le circuit de refroidissement. Ces pertes de charge sont issues du dimensionnement du circuit de refroidissement lors de la réalisation des plaques bipolaires, et peuvent se traduire par la formation de zones à fort débit ou à faible débit au sein du circuit de refroidissement.

Dans le cadre de l'invention, on cherche à adapter la distribution spatiale d'un paramètre d'intérêt représentatif de la résistance électrique de contact d'une cellule électrochimique, en particulier de la résistance de contact Rc entre la plaque bipolaire et une électrode adjacente. Le paramètre d'intérêt est donc également représentatif de la production d'énergie électrique, et donc d'énergie thermique. On cherche en particulier à déterminer la distribution spatiale du paramètre d'intérêt pour que la distribution spatiale de la température effective de la cellule en fonctionnement corresponde à celle d'une température de consigne, en tenant compte de la distribution spatiale de l'évacuation effective de chaleur que présente la cellule électrochimique.

Par paramètre représentatif de la production d'énergie électrique, on entend un paramètre dont la valeur influe localement sur la densité de courant $I_{x,y}$. Il s'agit ici en particulier de la résistance électrique de contact Rc de la cellule entre la plaque bipolaire et l'électrode adjacente, notamment sa couche de diffusion, ou d'un paramètre équivalent tel que la conductance de contact. En effet, plus la résistance de contact Rc est petite, meilleure sera la densité de courant produit par la cellule en fonctionnement, et inversement. La valeur de la résistance de contact dépend notamment de la force de serrage exercée sur la cellule, c'est-à-dire sur les deux plaques bipolaires en direction l'une de l'autre : plus la force de serrage est élevée, plus petite sera la résistance de contact, ce qui se traduit par une densité de courant élevée.

Par température de la cellule, on entend la température locale, c'est-à-dire la distribution spatiale de température de l'un ou l'autre des éléments de la cellule, par exemple de l'une des plaques bipolaires voire de l'une des électrodes. La température de la cellule peut ainsi correspondre à la distribution spatiale de température du circuit de refroidissement. La température effective de la cellule est la distribution spatiale de température de la cellule en fonctionnement, au point de polarisation définie par la tension de la cellule $U_{tot}$ et le courant $I_{tot}$, c'est-à-dire la densité locale de courant $I_{x,y}$ intégrée sur toute la surface de la cellule.

Par paramètre représentatif de l'évacuation de chaleur, on entend un paramètre dont la valeurtraduit la capacité de la cellule à évacuer localement la chaleur produite. Il peut s'agir en particulier du débit local, massique ou volumique, du fluide caloporteur circulant dans le circuit de refroidissement.

Enfin, par distribution spatiale d'un paramètre, on entend la valeur locale de ce paramètre en tout point de la cellule, ou plus précisément, en tout point (x,y) d'un plan parallèle à la cellule, au niveau de la zone dite active correspondant à l'étendue surfacique des couches actives des électrodes.

Ainsi, la cellule électrochimique dont le paramètre représentatif de la résistance de contact est réparti spatialement selon la distribution ainsi déterminée présente une température effective, ou température lors du fonctionnement de la cellule, sensiblement identique à la température de consigne. Cette température de consigne présente avantageusement une distribution spatiale sensiblement homogène, en scalaire ou en gradient. Par homogène en scalaire, on entend que la valeur locale de la température est sensiblement constant. Par homogène en gradient, on entend que le gradient local de température est sensiblement constant. Les valeurs locales de température peuvent cependant être non constantes tout en restant inférieures à des valeurs locales maximales prédéterminées. La cellule ne présente alors pas de zones de sur-température, ou points chauds, qui d'une part peuvent augmenter la cinétique des réactions de dégradation des éléments de la cellule et d'autre part peuvent générer des contraintes mécaniques susceptibles de dégrader la tenue mécanique des éléments de la cellule. La durée de vie de la cellule électrochimique est alors préservée. Par point chaud, on entend par exemple une zone de la cellule qui présente un pic de température ou un pic de gradient de température. Plus précisément, un point chaud peut être une zone où l'écart entre la température locale et la température d'entrée du circuit de refroidissement est supérieur au produit d'un coefficient et de l'écart de température entre l'entrée et la sortie du circuit de refroidissement, le coefficient pouvant être de l'ordre de 1,1 à 3 voire davantage, et est de préférence de l'ordre de 1,5. A titre d'exemple, pour une température de 77°C à l'entrée du circuit de refroidissement et de 80°C à la sortie du circuit, et pour un coefficient égal à 1,5, un point chaud est une zone de la cellule où la température locale excède 81,5°C.

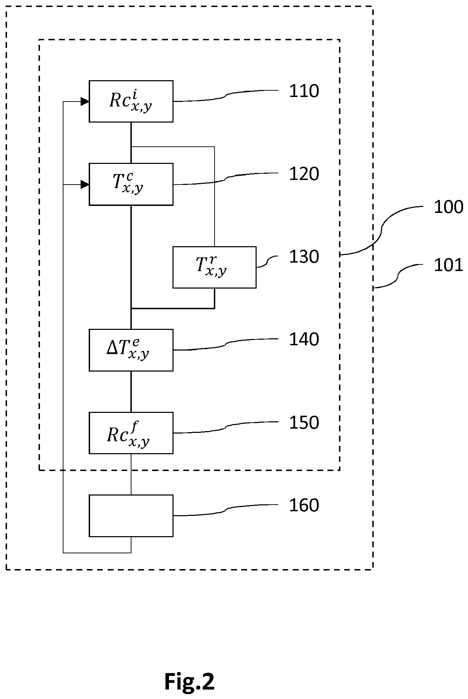

La figure 2 est un organigramme d'un procédé de détermination de la distribution spatiale du paramètre d'intérêt représentatif de la résistance électrique de contact de la cellule électrochimique, selon un premier mode de réalisation. Dans cet exemple, le paramètre d'intérêt est la résistance électrique de contact Rc de la cellule électrochimique entre la plaque bipolaire et l'électrode adjacente, et notamment la couche de diffusion de celle-ci, dont la valeur $Rc_{x,y}$ influe directement sur la densité locale de courant électrique $I_{x,y}$ localement produit lors de la réaction électrochimique et donc sur le flux local de chaleur produite $Q_{x,y}$.

D'une manière générale, selon ce premier mode de réalisation 100, on détermine une distribution spatiale optimisée $Rc_{x,y}^f$ de la résistance de contact Rc à partir de l'estimation de la distribution spatiale $\Delta T_{x,y}^e$ d'un écart $\Delta T^e$ entre une température effective $T^r$ de la cellule en fonctionnement dans laquelle la résistance de contact Rc est répartie spatialement selon une distribution initiale donnée, et une température de consigne $T^c$ prédéterminée. On est alors en mesure de réaliser une cellule dont la résistance de contact Rc présente la distribution optimisée $Rc_{x,y}^f$, de manière à ce que la température effective $T^r$ de la cellule modifiée soit sensiblement égale à la température de consigne $T^c$.

Lors d'une première étape 110, on définit une cellule électrochimique de référence au sein de laquelle la résistance de contact Rc est répartie spatialement selon une distribution initiale $Rc_{x,y}^i$. La cellule présente une structure identique ou similaire à celle décrite en référence à la figure 1. La distribution spatiale initiale $Rc_{x,y}^i$ de la résistance électrique peut être sensiblement homogène, c'est-à-dire ici qu'elle présente une valeur sensiblement constante en tout point de la zone active. A titre d'exemple, on considère que les surfaces de contact entre la plaque bipolaire et la couche de diffusion sont uniformément réparties, et que la force de serrage appliquée à la cellule est sensiblement uniforme.

Lors d'une étape 120, on définit une distribution spatiale $T_{x,y}^c$ d'une température de consigne $T^c$ de la cellule de référence lorsque celle-ci est en fonctionnement et produit une densité totale de courant $I_{tot}$ pour une tension $U_{tot}$ donnée. Au premier ordre, la température de consigne $T^c$ de la cellule peut correspondre à une température du fluide caloporteur au sein du circuit de refroidissement, la distribution de cette température dépendant alors notamment des valeurs en entrée $T_e^c$ et en sortie $T_s^c$ du circuit de refroidissement. A titre illustratif, la température d'entrée peut être fixée préalablement, par exemple à 75°C, et la température de sortie peut être estimée à partir de la puissance thermique $P_{th}$ à évacuer, celle-ci correspondant à la puissance électrique $P_e = I_{tot}.U_{tot}$ délivrée lors du fonctionnement de la cellule. La puissance thermique $P_{th}$ est estimée à partir de l'intégration sur la zone active du flux local de chaleur produite $Q_{x,y}$ obtenu à partir de la relation (1). L'estimation de la température de sortie $T_s^c$ est ensuite obtenue par corrélation de la puissance thermique $P_{th}$ estimée précédemment avec le débit total moyen $<D_{tot}>$ du liquide caloporteur dans le circuit de refroidissement, moyennant la capacité thermique $c_p$ du fluide caloporteur. On peut ensuite définir la distribution spatiale $T_{x,y}^c$ de la température de consigne $T^c$ à partir des valeurs de température du fluide caloporteur en entrée $T_e^c$ et en sortie $T_s^c$ du circuit de refroidissement, la distribution $T_{x,y}^c$ étant avantageusement homogène en gradient, c'est-à-dire que le gradient local de température de consigne est sensiblement constant.

Lors d'une étape 130, on obtient une distribution spatiale $T_{x,y}^r$ d'une première grandeur thermique représentative de la température de la cellule en fonctionnement. La première grandeur thermique est ici la température effective $T^r$ de la cellule électrochimique lorsqu'elle est en fonctionnement dans les mêmes conditions opératoires que celles considérées dans l'étape 120. Cette distribution $T_{x,y}^r$ n'est pas estimée mais est issue d'une mesure par des moyens expérimentaux ou numériques. Elle peut ainsi être obtenue par mesure expérimentale au sein d'une cellule électrochimique présentant les mêmes propriétés que la cellule de référence définie lors de l'étape 110, par exemple au moyen d'une carte S++ commercialisée par la société « S++ Simulation Services » comportant une plaque invasive insérée entre deux plaques bipolaires et adaptée à mesurer une distribution spatiale de température. La distribution $T_{x,y}^r$ de température effective peut également être obtenue par simulation numérique à partir d'un modèle électrochimique de cellule, par exemple celui décrit dans la publication d'Inoue et al., Numerical analysis of relative humidity distribution in polymer electrolyte fuel cell stack including cooling water, J. Power Sources 162 (2006) 81-93.

La distribution $T_{x,y}^r$ de la température effective $T^r$ obtenue par mesure expérimentale ou numérique prend ainsi en compte les inhomogénéités locales du flux de chaleur produite qui dépend de la densité locale de courant, ainsi que les inhomogénéités locales de l'évacuation de chaleur qui dépend notamment du débit local du fluide caloporteur dans le circuit de refroidissement.

Lors d'une étape 140, on estime la distribution spatiale d'une seconde grandeur thermique, ici une grandeur $\Delta T^e$ représentative d'un écart local entre la température effective $T^r$ et la température de consigne $T^c$. L'estimation de cette grandeur d'écart local $\Delta T^e$ est calculée à partir de la distribution spatiale $T^c_{x,y}$ de la température de consigne $T^c$ définie lors de l'étape 120 et de la distribution spatiale $T^r_{x,y}$ de la température effective $T^r$ mesurée lors de l'étape 130. Il peut s'agir de la différence entre la valeur locale de la température effective et celle de la température de consigne, ou d'un rapport entre ces valeurs, ou autre. On considère ici la différence termes à termes entre les distributions de la température effective et de la température de consigne : $\Delta T^e_{x,y} = T^r_{x,y} - T^c_{x,y}.$

Lors d'une étape 150, on détermine ensuite la distribution spatiale $Rc^f_{x,y}$ de la résistance de contact Rc en fonction de la distribution spatiale $\Delta T^e_{x,y}$ de l'écart local $\Delta T^e$.

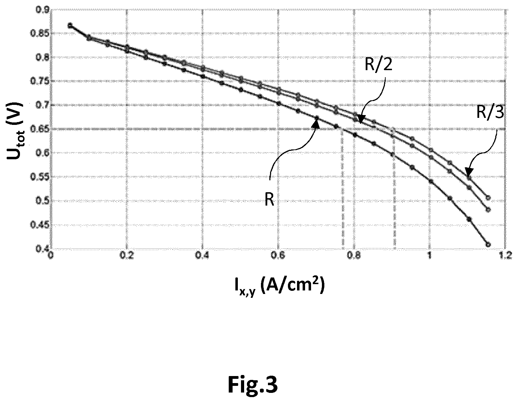

Selon une première variante, on calcule tout d'abord un coefficient correcteur, ou facteur de pondération, dont la distribution spatiale peut être proportionnelle termes à termes à celle $\Delta T^e_{x,y}$ de l'écart local $\Delta T^e$. A titre d'exemple, le coefficient correcteur varie continument entre une valeur minimale, par exemple inférieure ou égale à l'unité, jusqu'à une valeur maximale, à mesure que l'écart local $\Delta T^e$ varie respectivement entre une valeur sensiblement nulle à une valeur maximale. En référence à la figure 3, la valeur maximale du coefficient correcteur peut être déterminée à partir de courbes de polarisation relatives à la cellule de référence pour différentes valeurs locales de la résistance électrique de la cellule. Dans cet exemple de courbes de polarisation obtenues à l'aide d'un modèle électrochimique de cellule validé expérimentalement, la densité locale de courant diminue de 0,93A/m² à 0,77A/m² en multipliant la résistance électrique de la cellule par 3, pour une tension de cellule égale à 0,65V. Cette diminution de 17% de la densité locale de courant conduit à une diminution sensiblement identique de la production locale de chaleur. On détermine ensuite la distribution spatiale $Rc^f_{x,y}$ de la résistance électrique Rc par corrélation, par exemple par multiplication termes à termes, de la distribution spatiale initiale $Rc^i_{x,y}$ de la résistance électrique Rc avec la distribution spatiale du coefficient correcteur.

Selon une deuxième variante, on identifie tout d'abord au moins une zone $Z_i$ de la cellule dans laquelle l'écart $\Delta T^e$ présente une valeur supérieure à une valeur seuil prédéterminée, la valeur seuil étant par exemple représentative d'un point chaud. On détermine ensuite la distribution spatiale $Rc^f_{x,y}$ de la résistance électrique Rc par modification de la distribution spatiale initiale $Rc^i_{x,y}$ dans la zone $Z_i$ identifiée en fonction de la valeur locale de l'écart $\Delta T^e$ dans cette zone. A titre d'exemple, la distribution spatiale initiale $Rc^i_{x,y}$ peut être localement modifiée à partir d'un coefficient correcteur dont la valeur est proportionnelle à celle de l'écart $\Delta T^e$ dans cette zone. Comme dans la première variante, le coefficient correcteur varie continûment entre une valeur minimale et une valeur maximale préalablement déterminées par des courbes de polarisation similaires ou identiques à celles de la figure 3, moyennant une étape intermédiaire de soustraction des résistances ohmiques des éléments de la cellule pour déduire de la résistance électrique totale la valeur de la résistance de contact Rc.

On obtient ainsi une distribution spatiale $Rc^f_{x,y}$ de la résistance de contact Rc de la cellule électrochimique.

On est alors en mesure de modifier la distribution initiale $Rc^i_{x,y}$ de la résistance de contact Rc de la cellule de référence pour qu'elle présente la nouvelle distribution déterminée lors de l'étape 150. La cellule ainsi optimisée présente alors, en fonctionnement, une température effective dont la distribution spatiale est sensiblement égale à celle de la température de consigne. Dans la mesure où la distribution de la température de consigne est avantageusement homogène, la cellule en fonctionnement présente une température effective dont la distribution est également sensiblement homogène, permettant ainsi de préserver la durée de vie de la cellule.

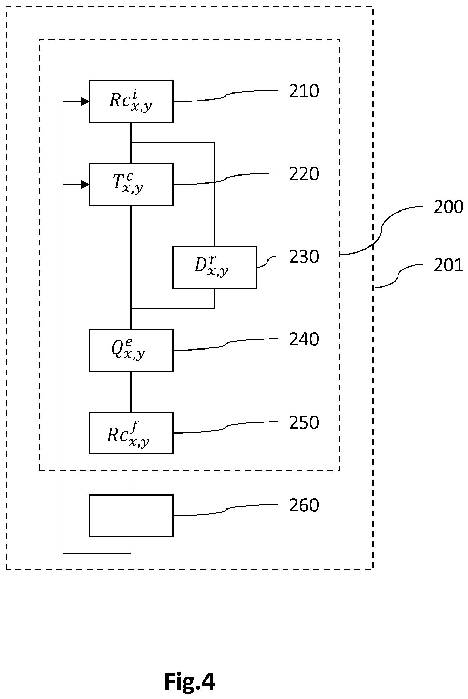

La figure 4 est un organigramme d'un procédé de détermination de la distribution spatiale d'un paramètre d'intérêt représentatif de la résistance électrique de contact de la cellule électrochimique, selon un deuxième mode de réalisation 200. Dans cet exemple, le paramètre d'intérêt est la résistance électrique de contact de la cellule électrochimique entre la plaque bipolaire et l'électrode adjacente, et notamment la couche de diffusion de celle-ci, dont la valeur influe directement sur la densité de courant électrique localement produit lors de la réaction électrochimique.

D'une manière générale, selon ce deuxième mode de réalisation, on détermine la distribution spatiale $Rc^f_{x,y}$

de la résistance de contact Rc à partir de l'estimation de la distribution spatiale de la production de chaleur nécessaire pour obtenir la distribution spatiale d'une température de consigne, en tenant compte de la distribution spatiale d'une grandeur thermique représentative de l'évacuation effective de chaleur dans la cellule. On est alors en mesure de réaliser une cellule présentant une résistance de contact Rc ayant la distribution spatiale déterminée, de manière à ce que la température effective soit alors sensiblement égale à la température de consigne. La cellule électrochimique, dont le paramètre d'intérêt est spatialement réparti selon la distribution optimisée, présente en fonctionnement une température sensiblement égale à la température de consigne. Il n'y a pas de formations de nouveaux points chauds, ou de nouvelles inhomogénéités de température, non voulus.

Cette approche, dite électrochimique, et non plus essentiellement thermique, est particulièrement avantageuse lorsqu'au moins une plaque bipolaire de la cellule électrochimique, voire les deux plaques bipolaires, sont formées de tôles accolées l'une à l'autre et présentant des bossages qui définissent un circuit de refroidissement bidimensionnel. Les bossages de chaque tôle, au niveau des faces, dites externes, des tôles, c'est-à-dire des faces orientées vers une électrode, définissent un circuit de distribution pour les espèces réactives. Au niveau des faces internes, c'est-à-dire des faces opposées aux faces externes, les bossages forment un circuit de refroidissement dans lequel est destiné à circuler un fluide caloporteur. Le circuit de refroidissement est dit linéaire lorsque les canaux de refroidissement ne communiquent pas entre eux, c'est-à-dire que le fluide caloporteur, entre l'entrée et la sortie du circuit de refroidissement, ne peut sensiblement pas passer d'un canal de refroidissement à un autre. Le circuit de refroidissement est dit bidimensionnel lorsque les canaux de refroidissement communiquent entre eux, de manière à former un réseau fluidique bidimensionnel et non pas linéaire. C'est le cas notamment lorsque les canaux de distribution d'une tôle ne sont pas parallèles à ceux de l'autre tôle.

Lors d'une première étape 210, on définit, ou fournit, une cellule électrochimique de référence au sein de laquelle la résistance de contact Rc entre une plaque bipolaire et la cellule adjacente de la cellule est répartie spatialement selon une distribution initiale $Rc^i_{x,y}$. La distribution spatiale initiale $Rc^i_{x,y}$ de la résistance de contact Rc peut être sensiblement homogène en scalaire, de sorte que la valeur locale est sensiblement constante en tout point de la zone active. La cellule présente une structure identique ou similaire à celle décrite en référence à la figure 1 et cette étape est similaire ou identique à l'étape 110 décrite précédemment. La cellule électrochimique considérée présente alors, en fonctionnement, une distribution spatiale de température dont au moins une valeur locale est supérieure ou égale à une valeur locale maximale prédéterminée. Cette dernière peut être constante ou différente en fonction du point considéré de la cellule électrochimique. Cette étape peut comporter :

- une phase de réalisation expérimentale ou de modélisation numérique d'une cellule électrochimique,
- une phase de mesure de la distribution spatiale de la température au sein de la cellule électrochimique en fonctionnement, puis
- une phase de comparaison de la distribution spatiale mesurée de la température vis-à-vis d'une distribution spatiale prédéterminée d'une température maximale. Les valeurs locales de cette distribution spatiale de température maximale sont dites valeurs locales maximales prédéterminées.

Lorsqu'au moins une valeur locale de la température mesurée est supérieure ou égale à une valeur locale maximale prédéterminée correspondante, c'est-à-dire pour la même position au sein de la distribution spatiale, la cellule électrochimique est alors fournie, c'est-à-dire considérée, pour les étapes suivantes du procédé de détermination.

Lors d'une étape 220, on définit une distribution spatiale $T^c_{x,y}$ d'une température de consigne $T^c$ de la cellule de référence lorsque celle-ci est en fonctionnement et produit une densité totale de courant $I_{tot}$ pour une tension $U_{tot}$ donnée. Cette étape est similaire ou identique à l'étape 120 décrite précédemment. Les valeurs locales de la distribution spatiale de la température de consigne sont inférieures à des valeurs locales maximales correspondantes.

De manière facultative, il est avantageux de préciser la distribution spatiale $T^c_{x,y}$ de la température de consigne $T^c$ en fonction de la distribution spatiale de la concentration en espèce réactive au niveau de la zone active entre l'entrée et la sortie du circuit de distribution correspondant. En effet, la consommation d'espèce réactive au sein de la zone active de la cellule conduit à une diminution progressive de la concentration d'espèce réactive le long du circuit de distribution. Cette diminution progressive se traduit par une diminution de la densité locale de courant produit par la cellule et donc de la production locale de chaleur, ce qui peut conduire à la formation d'inhomogénéités de la température de la cellule. Pour compenser cette diminution progressive de la production de chaleur, il est avantageux de définir une température de consigne qui tienne compte de la diminution de la concentration d'espèce réactive, de sorte que la température effective de la cellule en fonctionnement correspond à la température de consigne, celle-ci présentant avantageusement une distribution spatiale homogène. Pour cela, la distribution spatiale $\widetilde{T}^c_{x,y}$ de la température de consigne précisée $\widetilde{T}^c$ peut s'écrire, par exemple :

$$\widetilde{T}^c_{x,y} = T^c_{x,y} + K^i.[\ max(c^i_{x,y}) - c^i_{x,y}\ ] \tag{2}$$

où $c^i_{x,y}$ est la distribution spatiale de la concentration $c^i$ en espèce réactive i, par exemple en oxygène, et $K^i$ est une constante positive, par exemple proche de 1, qui peut ultérieurement être ajustée. La distribution spatiale $c^i_{x,y}$ de la concentration $c^i$ peut être estimée au premier ordre à partir du cheminement des canaux du circuit de distribution de l'espèce réactive considérée et en supposant une consommation homogène de l'espèce réactive i sur toute la zone active. Elle peut également être déterminée plus précisément par mesure expérimentale ou numérique de la distribution spatiale de la densité de courant dans une cellule similaire ou identique à la cellule de référence, qui permet de déduire celle de la concentration de l'espèce réactive. D'autres relations (2) peuvent convenir pour préciser la distribution spatiale de la température de consigne en tenant compte de l'évolution spatiale de la concentration en espèce réactive. On obtient ainsi une distribution spatiale $\widetilde{T}^c_{x,y}$ de la température de consigne $\widetilde{T}^c$ qui permet ainsi d'obtenir une distribution de la température effective de la cellule dont l'homogénéité est améliorée.

Par ailleurs, de manière facultative et éventuellement complémentaire à l'étape de précision de la température de consigne décrite précédemment, il est avantageux de préciser la distribution spatiale $T^c_{x,y}$ de la température de consigne $T^c$ en fonction de la distribution spatiale $\varphi_{x,y}$ de l'humidité relative $\varphi$ dans les circuits de distribution. L'humidité relative $\varphi$ est définie classiquement comme le rapport entre la pression partielle $P_{H2O}$ de la vapeur d'eau contenue localement dans le gaz circulant dans le circuit de distribution sur la pression de vapeur saturante $P_{sat}$. L'humidité relative $\varphi$ a un effet sur la cinétique des réactions électrochimiques. Aussi, pour compenser la variation locale de l'humidité relative, il est avantageux de définir une température de consigne qui compense cette variation locale, par exemple l'engorgement ou l'assèchement local des circuits de distribution, de sorte que la température effective de la cellule en fonctionnement présente une distribution spatiale homogène. Pour cela, la distribution spatiale $\widetilde{T}'^c_{x,y}$ de la température de consigne précisée $\widetilde{T}'^c$ peut s'écrire, par exemple :

$$\widetilde{T}'^c_{x,y} = T^c_{x,y} + K^\varphi.[\ \varphi_{x,y}\ /\ \varphi_{in}\ ] \tag{3}$$

où $\varphi_{x,y}$ est la distribution spatiale de l'humidité relative $\varphi$ dans le circuit de distribution, $\varphi_{in}$ est l'humidité relative en entrée du circuit de distribution, et $K^\varphi$ est une constante positive, par exemple proche de 1, qui peut ultérieurement être ajustée. La distribution $\varphi_{x,y}$ de l'humidité relative $\varphi$ peut être estimée au premier ordre à partir du cheminement des canaux du circuit de distribution considéré et en supposant une densité de courant homogène sur toute la zone active. Elle peut également être déterminée plus précisément par mesure expérimentale ou numérique de la distribution spatiale de la densité de courant dans une cellule similaire ou identique à la cellule de référence, qui permet de déduire celle de l'humidité relative. D'autres relations (3) peuvent convenir pour préciser la distribution spatiale de la température de consigne à partir de l'évolution spatiale de l'humidité relative. On obtient ainsi une distribution spatiale $\widetilde{T}^c_{x,y}$ de la température de consigne $\widetilde{T}^c$ qui permet ainsi d'obtenir une distribution de la température effective de la cellule dont l'homogénéité est améliorée.

Lors d'une étape 230, on obtient une distribution spatiale $D^r_{x,y}$ d'une première grandeur thermique représentative de l'évacuation de la chaleur $D^r$ au sein de la cellule en fonctionnement. La première grandeur thermique est ici le débit massique $D^r$ de fluide caloporteur dans le circuit de refroidissement. Cette distribution $D^r_{x,y}$ n'est pas estimée mais est issue d'une mesure par des moyens expérimentaux ou numériques. Elle peut ainsi être obtenue par mesure expérimentale au sein d'une cellule électrochimique présentant les mêmes propriétés que la cellule de référence définie lors de l'étape 210, par exemple au moyen d'une technique de type PIV (*Particle Image Velocimetry,* en anglais) ou de toute autre technique adaptée, réalisée dans un circuit de refroidissement présentant les mêmes caractéristiques dimensionnelles que celui de la cellule de référence. La distribution $D^r_{x,y}$ de débit massique $D^r$ peut également être obtenue par simulation numérique à partir d'un logiciel de simulation d'écoulement tel que, par exemple, FLUENT ou COMSOL.

Lors d'une étape 240, on estime la distribution spatiale $Q^e_{x,y}$ d'une seconde grandeur thermique $Q^e$ à partir de ladite distribution spatiale $T^c_{x,y}$ de la température de consigne $T^c$ définie lors de l'étape 220 et de ladite distribution spatiale $D^r_{x,y}$ du débit de fluide caloporteur $D^r$ obtenue lors de l'étape 230. La seconde grandeur thermique est représentative de la production locale de chaleur et correspond ici au flux local de chaleur $Q^e$ qu'évacue le fluide caloporteur $D^r$ pour obtenir la température de consigne $T^c$.

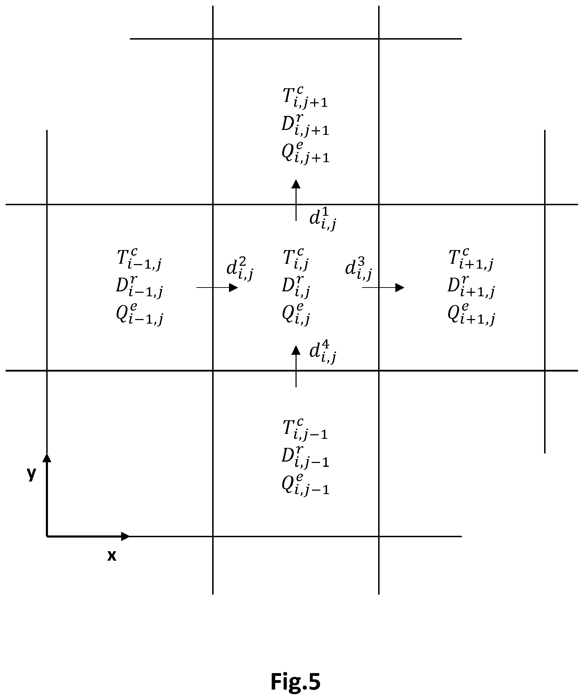

Pour cela, comme l'illustre la figure 5, on discrétise un modèle du circuit de refroidissement en un maillage bidimensionnel ou tridimensionnel, ici bidimensionnel, dont chaque maille est un volume élémentaire (i,j) traversé par le fluide caloporteur. Ainsi, chaque maille (i,j) du circuit de distribution présente deux grandeurs connues : la température locale $T^c_{i,j}$ de consigne et le débit local $D^r_{i,j}$ de fluide caloporteur ; et une grandeur à déterminer : le flux local de chaleur produite $Q^e_{i,j}$. On calcule ensuite les transferts thermiques et fluidiques entre la maille considérée et les mailles adjacentes en déterminant d'une part les différences de température, et d'autre part les débits du fluide caloporteur au niveau des quatre facettes de la maille considérée. Ce calcul peut être effectué par simulation numérique par ordinateur, sur ledit maillage. Cela revient à résoudre un modèle numérique discret exprimant la seconde grandeur thermique, à savoir ici le flux local de chaleur, en fonction de la température locale et de la première grandeur thermique, à savoir ici le débit local du fluide caloporteur. Le modèle numérique, dit électrochimique, peut être exprimé par la relation (6).

Les différences de température au niveau des quatre facettes de la maille (i,j) peuvent être calculées de la manière suivante :

$$\delta T^1_{i,j} = T^c_{i,j} - T^c_{i,j+1} \qquad (4\text{-}1)$$

$$\delta T^2_{i,j} = T^c_{i,j} - T^c_{i-1,j} \qquad (4\text{-}2)$$

$$\delta T^3_{i,j} = T^c_{i,j} - T^c_{i+1,j} \qquad (4\text{-}3)$$

$$\delta T^4_{i,j} = T^c_{i,j} - T^c_{i,j-1} \qquad (4\text{-}4)$$

Les débits du fluide caloporteur au niveau des quatre facettes de la maille (i,j) peuvent être obtenus par projection du débit massique $D^r_{i,j}$ (ici une donnée vectorielle) sur les vecteurs $e_x$ et $e_y$ passant respectivement par les mailles (i-1,j), (i,j) et (i+1,j), et par les mailles (i,j-1), (i,j) et (i,j+1) :

$$d^1_{i,j} = (D^r_{i,j} \cdot e_y + D^r_{i,j+1} \cdot e_y)/2 \qquad (5\text{-}1)$$

$$d^2_{i,j} = (D^r_{i,j} \cdot e_x + D^r_{i-1,j} \cdot e_x)/2 \qquad (5\text{-}2)$$

$$d^3_{i,j} = (D^r_{i,j} \cdot e_x + D^r_{i+1,j} \cdot e_x)/2 \qquad (5\text{-}3)$$

$$d^4_{i,j} = (D^r_{i,j} \cdot e_y + D^r_{i,j-1} \cdot e_y)/2 \qquad (5\text{-}4)$$

Par convention, on considère que le débit local $d_{i,j}$ est positif lorsque le fluide entre dans la maille (i,j) et négatif lorsqu'il en sort.

On calcule enfin la distribution spatiale $Q_{x,y}^{e}$ du flux $Q^e$ de chaleur produit par la cellule à partir de la relation :

$$Q_{x,y}^{e} \approx Q_{i,j}^{e} = \sum_{k=1}^{4} d_{i,j}^{k} . c_p . \delta T_{i,j}^{k} \qquad (6)$$

On obtient ainsi la distribution spatiale du flux de chaleur $Q^e$ que doit produire la cellule pour que la distribution de température effective corresponde à celle de la température de consigne, connaissant la distribution du débit massique effectif du fluide caloporteur dans le circuit de distribution.

Lors d'une étape 250, on détermine la distribution spatiale $Rc_{x,y}^{f}$ de la résistance de contact Rc en fonction de la distribution spatiale $Q_{x,y}^{e}$ du flux de chaleur produite $Q^e$. Pour cela, on peut estimer tout d'abord la distribution spatiale de la densité d'un signal électrique produit par la cellule en fonctionnement, par exemple la densité de courant $I^e$, à partir de la distribution spatiale $Q_{x,y}^{e}$ estimée du flux de chaleur produite $Q^e$. Dans la mesure où le flux de chaleur produite $Q^e$ est approximativement proportionnel à la densité de courant $I^e$, celle-ci peut être déterminée à partir de la relation :

$$I_{x,y}^{e} = Q_{x,y}^{e} . \frac{I_{tot}}{Q_{tot}} \qquad (7)$$

où $I_{tot}$ est la densité de courant totale délivrée par la cellule électrochimique en fonctionnement, et $Q_{tot}$ est le flux de chaleur produite totale obtenue par intégrale de la distribution spatiale $Q_{x,y}^{e}$ sur toute la surface active.

Ensuite, on détermine la nouvelle distribution spatiale $Rc_{x,y}^{f}$ de la résistance de contact Rc à partir de la densité locale du courant électrique $I_{x,y}^{e}$. Pour cela, une approche consiste à déterminer les valeurs minimale $Rc_{min}$ et maximale $Rc_{max}$ de la résistance de contact. Il peut s'agir d'une mesure expérimentale sur un échantillon de cellule présentant les mêmes propriétés que celles de la cellule de référence, ou d'une mesure par simulation numérique, par exemple avec le logiciel ANSYS (cf. Z. Wu, Y. Zhou, G. Lin, S. Wang, S. J. Hu, An improved model for predicting electrical contact resistance between bipolar plate and gas diffusion layer in proton exchange membrane fuel cells, J. Power Sources, Volume 182, Issue 1, 15 July 2008, 265-269). On calcule ensuite la distribution spatiale $Rc_{x,y}^{f}$ par exemple à partir de la relation :

$$Rc_{x,y}^{f} = \min \left( Rc_{max}, Rc_{min} \frac{I_{max}^{e}}{I_{x,y}^{e}} \right) \qquad (8)$$

où $I_{max}^{e}$ est la valeur maximale de la densité locale de courant $I_{x,y}^{e}$. La résistance locale de contact varie ainsi linéairement entre les valeurs minimale $Rc_{min}$ et maximale $Rc_{max}$ en fonction de la valeur locale de la densité de courant $I^e$. Bien entendu, toute autre loi, par exemple polynomiale, exponentielle ou logarithmique, faisant varier la résistance locale de contact de sorte que la valeur minimale $Rc_{min}$ corresponde à une densité locale de courant maximale et inversement, peut convenir. Les valeurs minimale $Rc_{min}$ et maximale $Rc_{max}$ peuvent être prédéterminées en fonction de la puissance électrique globale $U_{tot} . I_{tot}$ voulue de la cellule électrochimique, où $U_{tot}$ est la tension électrique et $I_{tot}$ la densité de courant électrique mesurées aux bornes de la cellule, ou d'un paramètre équivalent tel que le rendement de la cellule (la tension pour un densité de courant donnée).

On a ainsi déterminé la distribution spatiale $Rc_{x,y}^{f}$ de la résistance électrique de contact Rc qui tienne compte de la distribution de production d'énergie électrique $I^e$ et donc thermique $Q^e$ qu'il faudrait pour que la température effective de la cellule en fonctionnement corresponde à la température de consigne $T^c$, en considérant l'évacuation effective $D^r$ de la chaleur par le circuit de refroidissement. Dans la mesure où la température de consigne est avantageusement homogène spatialement, une cellule dont la résistance électrique Rc est répartie suivant la distribution spatiale $Rc_{x,y}^{f}$ ainsi déterminée présente, lorsqu'elle est en fonctionnement au point de polarisation $U_{tot}$ et $I_{tot}$, une température effective dont la distribution spatiale est homogène.

Un procédé de réalisation d'une cellule électrochimique est maintenant décrit. On considère une cellule électrochimique de référence identique ou similaire à la cellule de référence définie lors des étapes 110 et 210.

La cellule de référence présente une résistance électrique de contact Rc, entre la plaque bipolaire et la couche de diffusion de l'électrode adjacente, répartie spatialement selon une distribution initiale $Rc_{x,y}^{i}$. On détermine, par le procédé décrit précédemment en référence aux figures 2 ou 4, une distribution spatiale $Rc_{x,y}^{f}$ de la résistance de contact Rc de la cellule électrochimique. On réalise ensuite, lors d'une étape 160 (figure 2) ou 260 (figure 4), la cellule de sorte que la résistance électrique de contact Rc présente la distribution spatiale $Rc_{x,y}^{f}$ déterminée.

Pour cela, le procédé de réalisation d'une cellule électrochimique comporte une étape dans laquelle on modifie localement la contrainte mécanique subie par la cellule de référence, et en particulier subie par la couche de diffusion comprimée entre la plaque bipolaire et la couche active, de manière à obtenir la valeur locale déterminée $Rc_{x,y}^{f}$ de la résistance de contact Rc.

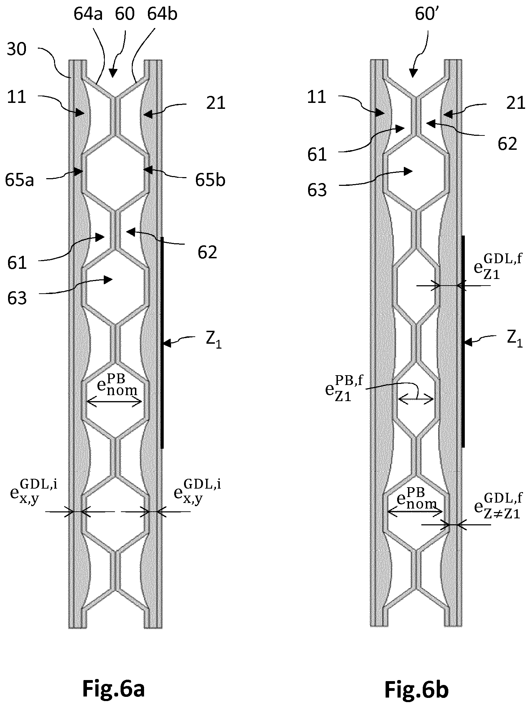

Selon une première variante faisant référence aux figures 6a et 6b, on ajuste localement l'épaisseur de la plaque bipolaire de manière à modifier la contrainte mécanique en compression subie par la couche de diffusion et en conséquence la résistance de contact Rc. Cet ajustement est réalisé de préférence sans modification de l'effort de serrage appliquée à la cellule au moyen de plaques terminales entre lesquelles est disposée la cellule électrochimique.

En référence à la figure 6a qui illustre une partie d'un exemple de cellules de référence dans lesquelles la résistance de contact Rc présente une distribution initiale $Rc_{x,y}^{i}$ sensiblement uniforme. Sont représentées une plaque bipolaire 60 en contact, d'une part, avec une couche de diffusion anodique 11 recouverte par une couche active et une membrane électrolytique 30 d'une première cellule de référence, et d'autre part avec une couche de diffusion cathodique 21 recouverte par une couche active et une membrane électrolytique d'une seconde cellule de référence. La plaque bipolaire 60 est ici formée de l'assemblage de deux tôles 64a, 64b électriquement conductrices, par exemple métalliques, présentant des bossages 65a, 65b formant un circuit de distribution d'hydrogène 61 en contact avec la couche de diffusion anodique 11 et un circuit de distribution d'oxygène 62 en contact avec la couche de diffusion cathodique 21. Un circuit de refroidissement 63 assurant l'écoulement d'un fluide caloporteur est également présent. La plaque bipolaire 60 est en contact avec les couches de diffusion 11, 21 au niveau des bossages 65a, 65b formant les conduits de refroidissement 63.

La résistance électrique de contact entre la plaque bipolaire 60 et chaque couche de diffusion 11, 21 est, par définition, formée dans les zones de contact mécanique entre ces éléments. Dans la mesure où la plaque bipolaire 60 présente une épaisseur nominale $e_{nom}^{PB}$ spatialement constante, correspondant ici à la dimension des conduits de refroidissement 63 suivant un axe sensiblement orthogonal au plan moyen de la plaque bipolaire, et sous l'application d'une force de serrage spatialement uniforme au niveau des cellules, les couches de diffusion 11 et 21 sont localement comprimées entre les couches actives et la plaque bipolaire de manière homogène. Par épaisseur de la plaque bipolaire, on entend la dimension de la plaque, sensiblement orthogonale au plan moyen de la plaque, dans les zones de contact avec les couches de diffusion. Les couches de diffusion présentent donc localement une épaisseur $e_{x,y}^{GDL,i}$ uniforme dans les zones de contact mécanique avec la plaque bipolaire, et subie une contrainte mécanique de compression $\sigma_{x,y}^{i}$ également uniforme. La distribution initiale $Rc_{x,y}^{i}$ de la résistance de contact Rc est en conséquence sensiblement uniforme. On suppose ici que les cellules de référence présentent une zone $Z_1$ présentant une sur-température, ou point chaud, c'est-à-dire que la valeur locale de la température effective est supérieure à une valeur seuil prédéterminée.

En référence à la figure 6b qui illustre la partie de cellules similaire à celle de la figure 6a, dans laquelle la résistance de contact Rc présente une distribution déterminée $Rc_{x,y}^{f}$ par le procédé selon l'invention. La valeur locale $Rc_{Z1}^{f}$ de la résistance de contact est supérieure à la valeur initiale $Rc_{Z1}^{i}$ de manière à diminuer la production locale d'énergie électrique et donc thermique. Pour cela, on diminue la contrainte mécanique de compression mécanique $\sigma_{Z1}^{f}$ vis-à-vis de sa valeur initiale $\sigma_{Z1}^{i}$ en augmentant l'épaisseur locale $e_{Z1}^{GDL,f}$ de la couche de diffusion par une modification locale de l'épaisseur $e_{Z1}^{PB,f}$ de la plaque bipolaire, plus précisément par une diminution, dans la zone Z1, de la dimension transversale des conduits de refroidissement 63 suivant un axe orthogonal au plan moyen de la cellule.

Autrement dit, on peut réaliser les étapes suivantes :

a. Identification d'au moins une zone $Z_i$ de sur-température dans la cellule de référence dont la résistance de contact Rc présente une distribution spatiale initiale $Rc_{Zi}^{i}$ ;

b. Détermination, par le procédé selon l'invention, de la valeur locale $Rc_{Zi}^{f}$ de la résistance de contact Rc dans la zone Zi pour laquelle la température effective de la cellule est sensiblement égale à une température de consigne permettant ici de réduire la sur-température ;

c. Estimation de la contrainte mécanique locale $\sigma_{Zi}^{f}$ subie par la couche de diffusion permettant d'obtenir la valeur locale $Rc_{Zi}^{f}$ déterminée, pour un effort de serrage identique à celui appliqué à la cellule de référence ;

d. Estimation de l'épaisseur locale $e_{Zi}^{GDL,f}$ de la couche de diffusion permettant d'obtenir la contrainte mécanique $\sigma_{Zi}^{f}$ estimée ;

e. Calcul de l'épaisseur locale $e_{Zi}^{PB,f}$ de la plaque bipolaire permettant d'obtenir l'épaisseur $e_{Zi}^{GDL,f}$ estimée puis réalisation de la cellule comportant une plaque bipolaire dont l'épaisseur locale est ainsi modifiée.

L'estimation de l'épaisseur locale $e_{x,y}^{GDL,f}$ de la couche de diffusion permettant d'obtenir la valeur déterminée $Rc_{Zi}^{f}$ de la résistance de contact peut être effectuée à partir de mesures expérimentales reliant d'une part la résistance électrique R à la contrainte mécanique de compression σ subie par la couche de diffusion, et d'autre part la contrainte de compression σ à l'épaisseur $e^{GDL}$ de la couche de diffusion. L'article d'Escribano et al. intitulé Characterization of PEMFCs gas diffusion loyers properties, Journal of Power Sources, 156 (2006) 8-13 montre l'évolution de la résistance électrique de la cellule et l'épaisseur de la couche de diffusion en fonction de la contrainte de compression subie.

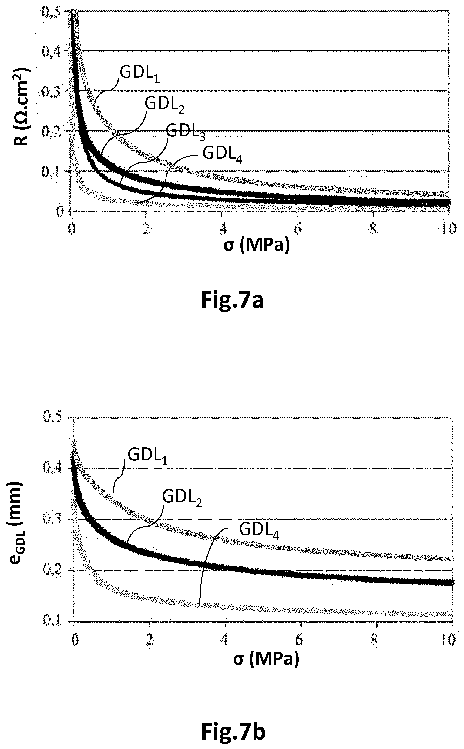

La figure 7a illustre un exemple d'évolution de la résistance électrique R de la cellule en fonction de la contrainte de compression subie, pour différents types de couches de diffusion, décrit dans l'article d'Escribano 2006. Comme indiqué par les auteurs, l'évolution de la résistance électrique R est représentative de celle de la résistance de contact Rc. Aussi, connaissant les différentes résistances ohmiques de la cellule, on déduit la valeur de la résistance de contact Rc en soustrayant les résistances ohmiques de la résistance électrique R. A titre d'exemple, pour augmenter localement la résistance électrique de 8mΩ.cm² à 24mΩ.cm², la contrainte de compression doit passer de 2,5MPa à 0,2MPa.

La figure 7b illustre un exemple d'évolution de l'épaisseur de la couche de diffusion en fonction de la contrainte de compression subie, pour différents types de couches de diffusion, décrit dans l'article d'Escribano 2006. Connaissant la contrainte mécanique de compression $\sigma_{x,y}^{f}$ à générer dans la couche de diffusion, on déduit l'épaisseur $e_{x,y}^{GDL,f}$ de la couche de diffusion à obtenir. A titre d'exemple, en générant une contrainte de compression passant de 2,5MPa à 0,2MPa, l'épaisseur de la couche de diffusion doit passer de 0,22mm à 0,32mm. La plaque bipolaire est ensuite réalisée ou localement modifiée pour que, une fois la cellule assemblée et sous l'application d'une force de serrage identique à celle appliquée à la cellule de référence, l'épaisseur locale de la plaque bipolaire dans la zone Zi permette d'obtenir l'épaisseur locale estimée de la couche de diffusion.

Plus généralement, on augmente l'épaisseur locale de la couche de diffusion dans une zone Zi dans laquelle la température effective de la cellule de référence est supérieure à la température de consigne, de manière proportionnelle à la valeur locale de cet écart, en diminuant l'épaisseur locale de la plaque bipolaire. Cette diminution d'épaisseur de la plaque bipolaire conduit à une contrainte de compression diminuée dans la couche de diffusion, ce qui augmente la résistance locale de contact Rc et entraîne une diminution de la production locale d'énergie électrique et donc thermique. A l'inverse, on peut augmenter l'épaisseur de la couche de diffusion dans une autre zone Zi dans laquelle la température effective de la cellule de référence est inférieure à la température de consigne, de manière proportionnelle à la valeur locale de cet écart, en augmentant l'épaisseur locale de la plaque bipolaire. Ainsi, cette augmentation d'épaisseur de la plaque bipolaire conduit à une contrainte de compression augmentée dans la couche de diffusion, ce qui diminue la résistance de contact Rc et entraîne une augmentation de la production locale d'énergie électrique et donc thermique.

Il est à noter que la variation de l'épaisseur de la plaque bipolaire entraîne également une variation de la section droite des canaux de distribution des espèces réactives, ce qui induit également une variation à la production d'énergie électrique et donc thermique qui se conjugue avec la variation de la résistance de contact.

Ainsi, une cellule électrochimique dont la structure est similaire à la cellule de référence mais équipée d'au moins une plaque bipolaire dont l'épaisseur varie localement, tel que décrit précédemment, permet en fonctionnement de fournir une température effective correspondant à la température de consigne, limitant alors avantageusement les zones de sur-température.

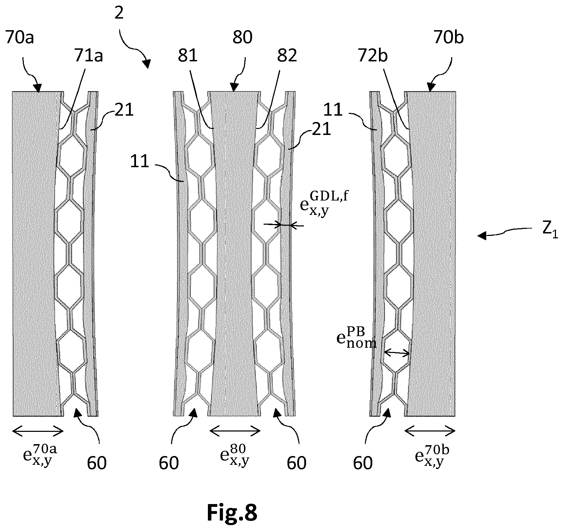

Selon une seconde variante faisant référence à la figure 8, on ajuste localement l'épaisseur d'au moins une plaque terminale enserrant l'empilement de cellules et/ou l'épaisseur d'une plaque insérée 80 à l'intérieur de l'empilement de cellules, de manière à modifier la contrainte mécanique en compression subie par la couche de diffusion des cellules électrochimiques et en conséquence la résistance de contact Rc entre chaque couche active d'électrode et la plaque bipolaire adjacente. Cet ajustement est réalisé de préférence sans modification de l'effort de serrage appliqué à la cellule par les plaques terminales, ni modification de l'épaisseur locale des plaques bipolaires des cellules électrochimiques.

En référence à la figure 8 qui illustre de manière partielle et schématique une partie d'un empilement 2 de cellules électrochimiques dans laquelle la résistance de contact Rc présente une distribution spatiale $Rc^f_{x,y}$ déterminée à partir du procédé décrit précédemment. Sont représentés sur la figure deux plaques terminales 70a, 70b et un empilement 2 de cellules électrochimiques enserré entre les plaques terminales. Les cellules présentent une structure identique ou similaire les unes aux autres et les plaques bipolaires 60 ont ici une épaisseur sensiblement uniforme. Au moins l'une des plaques terminales, ici les deux plaques 70a, 70b, présente une épaisseur $e^{70a}_{x,y}$, $e^{70b}_{x,y}$ qui varie localement de manière à ce que la résistance de contact des cellules présente la distribution spatiale $Rc^f_{x,y}$ déterminée. Plus précisément, chaque plaque terminale 70a, 70b comporte une surface 71a, 72b en contact avec l'empilement de cellules, structurée de manière à présenter localement des protubérances ou des échancrures, qui entraînent, une fois l'empilement de cellules enserré entre les plaques terminales, une variation locale de la contrainte de compression au niveau des couches de diffusion 11, 21 se traduisant par une variation de leur épaisseur locale $e^{GDL,f}_{x,y}$ et dont de la résistance de contact $Rc^f_{x,y}$ entre chaque couche active et la plaque bipolaire adjacente. Par protubérance et échancrure, on entend une structuration locale de la surface de contact de manière à former respectivement une zone de la surface en saillie ou en retrait vis-à-vis d'un plan principal sensiblement tangent à la surface de contact.

En variante ou en complément, comme représenté sur la figure 8, une plaque supplémentaire 80 peut être insérée entre deux cellules adjacentes dans l'empilement de cellules, ici entre deux plaques bipolaires. De manière similaire, cet insert 80 présente une épaisseur $e^{80}_{x,y}$ qui varie localement de manière à modifier la contrainte mécanique subie par les couches de diffusion et donc leur épaisseur locale $e^{GDL,f}_{x,y}$, se traduisant par une variation en conséquence de la résistance de contact locale $Rc^f_{x,y}$.

Plus généralement, on diminue l'épaisseur d'au moins une plaque terminale et/ou d'un insert par rapport à un plan principal sensiblement tangent à la surface de contact de la plaque ou de l'insert, ou on réalise localement une échancrure, dans une zone $Z_i$ dans laquelle la température effective de la cellule de référence est supérieure à la température de consigne, de manière proportionnelle à la valeur locale de cet écart. Ainsi, on diminue la contrainte de compression subie par les couches de diffusion et on en augmente l'épaisseur locale. Cela se traduit par une augmentation locale de la résistance de contact et donc à une diminution de la production locale d'énergie électrique et donc thermique. Ainsi, la sur-température dans cette zone Zi est diminuée. De manière similaire à ce qui a été décrit précédemment en référence aux figures 7a et 7b, la profondeur de l'échancrure ou la hauteur de la protubérance vis-à-vis d'un plan principal sensiblement tangent à la surface de contact de la plaque ou de l'insert est déterminée en fonction de l'épaisseur estimée des couches de diffusion permettant d'obtenir la valeur locale déterminée de la résistance de contact.

Ainsi, un réacteur électrochimique comportant au moins une plaque terminale en contact avec un empilement de cellules électrochimiques et/ou une plaque insérée à l'intérieur de l'empilement dont l'épaisseur varie localement tel que décrit précédemment permet, en fonctionnement, de fournir une température effective correspondant à la température de consigne, limitant alors avantageusement les zones de sur-température.

Comme le montre les figures 2 et 4, à l'issue de l'étape de réalisation de la cellule électrochimique ou d'un réacteur électrochimique pour que la résistance électrique de contact Rc présente la distribution spatiale $Rc_{x,y}^{f}$ préalablement déterminée, une étape de mesure de la distribution spatiale de la température effective de la cellule en fonctionnement est effectuée, puis celle-ci est comparée à la température de consigne $T^C$. Les étapes 110, 120 ; 210, 220 peuvent être réitérées en modifiant les propriétés de la nouvelle cellule de référence et/ou en affinant la distribution spatiale de la température de consigne, notamment en ajustant les coefficients $K^i$ et $K^\varphi$. Les étapes suivantes du procédé de détermination de la distribution de la résistance électrique de contact Rc puis de réalisation de la cellule ou du réacteur électrochimique sont ensuite effectuées, puis est réalisée une nouvelle étape de comparaison entre la température effective de la cellule en fonctionnement et la température de consigne, jusqu'à ce qu'un paramètre de convergence indique que cet écart est inférieur à une valeur seuil prédéterminée.

**Revendications**

**1.** Procédé de détermination d'une distribution spatiale $(Rc_{x,y}^{f})$ d'un paramètre d'intérêt (Rc) représentatif d'une résistance électrique de contact entre une plaque bipolaire et une électrode adjacente d'une cellule électrochimique, ladite cellule comportant deux électrodes séparées l'une de l'autre par un électrolyte et disposées entre des plaques bipolaires adaptées à amener des espèces réactives aux électrodes et à évacuer de la chaleur produite par la cellule en fonctionnement, comprenant les étapes suivantes :

i) fourniture (110 ; 210) d'une cellule électrochimique, au sein de laquelle le paramètre d'intérêt (Rc) est réparti selon une distribution spatiale initiale $(Rc_{x,y}^{i})$, pour laquelle la distribution spatiale d'une température au sein de la cellule électrochimique en fonctionnement présente au moins une valeur locale supérieure ou égale à une valeur locale maximale prédéterminée ;

ii) définition (120 ; 220) d'une distribution spatiale $(T_{x,y}^{c})$ d'une température de consigne ($T^c$) au sein de la cellule électrochimique en fonctionnement, telle que les valeurs locales de température sont inférieures à des valeurs locales maximales prédéterminées ;

iii) mesure (130; 230) d'une distribution spatiale $(D_{x,y}^{r})$ d'une première grandeur thermique représentative de l'évacuation locale de la chaleur ($D^r$) au sein de ladite cellule électrochimique en fonctionnement ;

iv) estimation (140 ; 240) d'une distribution spatiale $(Q_{x,y}^{e})$ d'une seconde grandeur thermique ($Q^e$) représentative de la production locale de chaleur ($Q^e$) au sein de ladite cellule électrochimique en fonctionnement, en fonction de ladite distribution spatiale $(T_{x,y}^{c})$ de la température de consigne ($T^c$) et de ladite distribution spatiale $(D_{x,y}^{r})$ de la première grandeur thermique ($D^r$), de sorte que la distribution spatiale de température de ladite cellule électrochimique en fonctionnement, dont la première grandeur thermique ($D^r$) présente ladite distribution spatiale mesurée $(D_{x,y}^{r})$ et la seconde grandeur thermique ($Q^e$) présente ladite distribution spatiale estimée $(Q_{x,y}^{e})$, soit sensiblement égale à celle $(T_{x,y}^{c})$ de la température de consigne ($T^c$) ;

v) détermination (150 ; 250) d'une distribution spatiale $(Rc_{x,y}^{f})$ du paramètre d'intérêt (Rc) en fonction de la distribution spatiale estimée $(Q_{x,y}^{e})$ de la seconde grandeur thermique ($Q^e$) ;

et dans lequel l'étape d'estimation d'une distribution spatiale de la seconde grandeur thermique comporte :

- une phase de réalisation d'un maillage d'un circuit de refroidissement d'au moins une plaque bipolaire de la cellule électrochimique dans lequel est destiné à s'écouler un fluide caloporteur ;
- une phase de simulation numérique par ordinateur de la seconde grandeur thermique, sur ledit maillage, par résolution d'un modèle numérique discret exprimant la seconde grandeur thermique en fonction de la température locale et de la première grandeur thermique.

2. Procédé de détermination selon la revendication 1, dans lequel le paramètre d'intérêt est la résistance électrique de contact (Rc) de la cellule électrochimique, la première grandeur thermique est représentative de l'évacuation locale (D$^r$) de la chaleur produite par la cellule en fonctionnement, et la seconde grandeur thermique est représentative de la production locale de chaleur (Q$^e$) par la cellule en fonctionnement.

3. Procédé de détermination selon la revendication 1 ou 2, dans lequel les plaques bipolaires sont formées de deux tôles accolées l'une à l'autre, chaque tôle comportant des bossages formant au niveau d'une face dite externe un circuit de distribution d'une espèce réactive, les bossages des tôles formant ensemble, au niveau de faces dites internes opposées aux faces externes, un circuit de refroidissement comportant des canaux de refroidissement qui communiquent fluidiquement entre eux entre une entrée et une sortie du circuit de refroidissement.

4. Procédé de détermination selon l'une quelconque des revendications 1 à 3, dans lequel l'étape de détermination de la distribution spatiale du paramètre d'intérêt est en outre effectuée en fonction d'une valeur prédéterminée de puissance électrique globale de la cellule électrochimique.

5. Procédé de détermination selon l'une quelconque des revendications 1 à 4, dans lequel la première grandeur thermique est le débit local effectif (D$^r$) mesuré d'un fluide caloporteur circulant dans un circuit de refroidissement d'une plaque bipolaire de la cellule, et la seconde grandeur thermique est le flux local de chaleur (Q$^e$) produite par la cellule en fonctionnement.

6. Procédé de détermination selon la revendication 5, dans lequel l'étape v) comporte :

   a) une première sous-étape dans laquelle on estime la distribution spatiale de la densité d'un signal électrique (I$^e$) produit par la cellule en fonctionnement, à partir de la distribution spatiale estimée du flux de chaleur produite (Q$^e$), et
   b) une deuxième sous-étape dans laquelle on détermine la distribution spatiale du paramètre d'intérêt (Rc) à partir de la densité locale du signal électrique (I$^e$).

7. Procédé de réalisation d'une cellule électrochimique, comportant les étapes dans lesquelles :

   i) on considère une cellule électrochimique de référence comportant deux électrodes séparées l'une de l'autre par un électrolyte et disposées entre des plaques bipolaires adaptées à amener des espèces réactives aux électrodes et à évacuer de la chaleur produite par la cellule en fonctionnement, les plaques bipolaires présentant une distribution spatiale initiale $\left(e_{x,y}^{PB,i}\right)$ d'épaisseur, la cellule présentant un paramètre d'intérêt représentatif de la résistance électrique de contact (Rc) réparti spatialement selon une distribution initiale $\left(Rc_{x,y}^{i}\right)$ ;
   ii) on détermine, par le procédé (100 ; 200) selon l'une quelconque des revendications précédentes, une distribution spatiale $\left(Rc_{x,y}^{f}\right)$ du paramètre d'intérêt (Rc) ;
   iii) on réalise (160 ; 260) ladite cellule à partir de la cellule de référence, de sorte que le paramètre d'intérêt (Rc) présente la distribution spatiale $\left(Rc_{x,y}^{f}\right)$ déterminée.

8. Procédé de réalisation d'une cellule électrochimique selon la revendication 7, dans laquelle on détermine une distribution spatiale $\left(e_{x,y}^{PB,f}\right)$ d'épaisseur d'au moins l'une des plaques bipolaires en fonction de la distribution spatiale $\left(Rc_{x,y}^{f}\right)$ déterminée.

9. Procédé de réalisation d'une cellule électrochimique selon la revendication 8, dans lequel ladite plaque bipolaire présente localement une épaisseur inférieure ou supérieure $\left(e_{x,y}^{PB,f}\right)$ à une épaisseur nominale de la plaque sensiblement égale à l'épaisseur initiale $(e_{x,y}^{PB,i})$, dans des zones préalablement identifiées à partir de ladite distribution spatiale déterminée $(Rc_{x,y}^{f})$ de la résistance électrique de contact (Rc).

10. Procédé de réalisation d'un réacteur électrochimique, comportant les étapes dans lesquelles :

   i. on considère un réacteur électrochimique de référence comportant un empilement de cellules électrochimiques enserrées et comprimées entre deux plaques terminales, chaque cellule comprenant deux électrodes séparées l'une de l'autre par un électrolyte et disposées entre des plaques bipolaires adaptées à amener des espèces réactives aux électrodes et à évacuer de la chaleur produite par la cellule en fonctionnement, et présentant un paramètre d'intérêt représentatif de la résistance électrique de contact (Rc) réparti spatialement selon une distribution initiale $(Rc_{x,y}^{i})$ ;
   ii. on détermine, par le procédé (100 ; 200) selon l'une quelconque des revendications 1 à 6, une distribution spatiale $(Rc_{x,y}^{f})$ du paramètre d'intérêt (Rc) pour au moins l'une des cellules ;
   iii. on réalise (160 ; 260) ledit réacteur électrochimique à partir du réacteur de référence, de sorte que le paramètre d'intérêt (Rc) présente la distribution spatiale $(Rc_{x,y}^{f})$ déterminée.

11. Procédé de réalisation d'un réacteur électrochimique selon la revendication 10, dans laquelle on détermine une distribution spatiale $(e_{x,y}^{70a,70b})$ d'épaisseur d'au moins l'une des plaques terminales, et/ou une distribution spatiale $(e_{x,y}^{80})$ d'épaisseur d'au moins une plaque insérée entre deux cellules adjacentes dudit empilement, en fonction de la distribution spatiale $(Rc_{x,y}^{f})$ déterminée.

12. Support d'enregistrement d'informations, comportant des instructions pour la mise en oeuvre du procédé de détermination selon l'une quelconque des revendications 1 à 6, ces instructions étant aptes à être exécutées par un processeur.

## Patentansprüche

1. Verfahren zur Bestimmung einer räumlichen Verteilung $(Rc_{x,y}^{f})$ eines Parameters von Interesse (Rc), der für einen elektrischen Kontaktwiderstand zwischen einer bipolaren Platte und einer angrenzenden Elektrode einer elektrochemischen Zelle repräsentativ ist, wobei die Zelle zwei voneinander durch ein Elektrolyt getrennte Elektroden umfasst, die zwischen bipolaren Platten angeordnet sind, die geeignet sind, reaktive Gattungen zu den Elektroden zu führen und von der Zelle während des Betriebs erzeugte Wärme abzuleiten, umfassend die folgenden Schritte:

   i) Bereitstellung (110; 210) einer elektrochemischen Zelle, in der der Parameter von Interesse (Rc) nach einer anfänglichen räumlichen Verteilung $(Rc_{x,y}^{i})$ verteilt ist, bei der die räumliche Verteilung einer Temperatur innerhalb der elektrochemischen Zelle während des Betriebs mindestens einen lokalen Wert größer oder gleich einem vorbestimmten lokalen Maximalwert aufweist;
   ii) Definition (120; 220) einer räumlichen Verteilung $(T_{x,y}^{c})$ einer Solltemperatur $(T^{c})$ innerhalb der elektrochemischen Zelle während des Betriebs, so dass die lokalen Temperaturwerte kleiner als vorbestimmte lokale Maximalwerte sind;
   iii) Messung (130; 230) einer räumlichen Verteilung $(D_{x,y}^{r})$ einer ersten thermischen Größe, die für die lokale Ableitung der Wärme $(D^{r})$ innerhalb der elektrochemischen Zelle während des Betriebs repräsentativ ist;
   iv) Schätzung (140; 240) einer räumlichen Verteilung $(Q_{x,y}^{e})$ einer zweiten thermischen Größe $(Q^{e})$, die für die lokale Wärmeproduktion $(Q^{e})$ innerhalb der elektrochemischen Zelle während des Betriebs repräsentativ ist, in Abhängigkeit von der räumlichen Verteilung $(T_{x,y}^{c})$ der Solltemperatur $(T^{c})$ und der räumlichen Verteilung $(D_{x,y}^{r})$ der ersten thermischen Größe $(D^{r})$, so dass die räumliche Temperaturverteilung der elektrochemischen Zelle während des Betriebs, deren erste thermische Größe $(D^{r})$ die gemessene räumliche Verteilung $(D_{x,y}^{r})$ aufweist, und deren zweite thermische Größe $(Q^{e})$ die geschätzte räumliche Verteilung $(Q_{x,y}^{e})$ aufweist, im Wesentlichen

gleich jener ($T^c_{x,y}$) der Solltemperatur ($T^c$) ist;

v) Bestimmung (150; 250) einer räumlichen Verteilung ($Rc^f_{x,y}$) des Parameters von Interesse (Rc) in Abhängigkeit von der geschätzten räumlichen Verteilung ($Qe_{x,y}$) der zweiten thermischen Größe ($Q^e$),

wobei der Schritt der Schätzung einer räumlichen Verteilung der zweiten thermischen Größe umfasst:

- eine Phase der Herstellung eines Netzes einer Kühlschaltung mindestens einer bipolaren Platte der elektrochemischen Zelle, in der eine Wärmeträgerflüssigkeit abfließen soll;
- eine Phase der digitalen Simulation durch einen Computer der zweiten thermischen Größe auf dem Netz durch Auflösung eines diskreten digitalen Modells, das die zweite thermische Größe in Abhängigkeit von der lokalen Temperatur und der ersten thermischen Größe ausdrückt.

2. Bestimmungsverfahren nach Anspruch 1, bei dem der Parameter von Interesse der elektrische Kontaktwiderstand (Rc) der elektrochemischen Zelle ist, die erste thermische Größe für die lokale Ableitung ($D^r$) der von der Zelle während des Betriebs produzierten Wärme repräsentativ ist, und die zweite thermische Größe für die lokale Wärmeproduktion ($Q^e$) durch die Zelle während des Betriebs repräsentativ ist.

3. Bestimmungsverfahren nach Anspruch 1 oder 2, bei dem die bipolaren Platten von zwei aneinander haftenden Blechen gebildet sind, wobei jedes Blech Erhöhungen umfasst, die im Bereich einer so genannten Außenseite eine Verteilungsschaltung einer reaktiven Gattung bilden, wobei die Erhöhungen der Bleche gemeinsam im Bereich von so genannten Innenseiten, die den Außenseiten gegenüberliegen, eine Kühlschaltung bilden, umfassend Kühlkanäle, die miteinander zwischen einem Eingang und einem Ausgang der Kühlschaltung in Fluidverbindung stehen.

4. Bestimmungsverfahren nach einem der Ansprüche 1 bis 3, bei dem der Schritt der Bestimmung der räumlichen Verteilung des Parameters von Interesse ferner in Abhängigkeit von einem vorbestimmten Wert der globalen elektrischen Leistung der elektrochemischen Zelle erfolgt.

5. Bestimmungsverfahren nach einem der Ansprüche 1 bis 4, bei dem die erste thermische Größe die effektive gemessene lokale Durchflussmenge ($D^r$) einer Wärmeträgerflüssigkeit ist, die in einer Kühlschaltung einer bipolaren Platte der Zelle zirkuliert, und die zweite thermische Größe der lokale Wärmestrom ($Q^e$) ist, der von der Zelle während des Betriebs produziert wird.

6. Bestimmungsverfahren nach Anspruch 5, bei dem der Schritt v) umfasst:

a) einen ersten Unterschritt, bei dem die räumliche Verteilung der Dichte eines elektrischen Signals ($I^e$), das von der Zelle während des Betriebs erzeugt wird, auf Basis der geschätzten räumlichen Verteilung des produzierten Wärmestroms ($Q^e$) geschätzt wird, und
b) einen zweiten Unterschritt, bei dem die räumliche Verteilung des Parameters von Interesse (Rc) auf Basis der lokalen Dichte des elektrischen Signals ($I^e$) bestimmt wird.

7. Verfahren zur Herstellung einer elektrochemischen Zelle, umfassend die folgenden Schritte:

i) Betrachtung einer elektrochemischen Referenzzelle, umfassend zwei voneinander durch ein Elektrolyt getrennte Elektroden, die zwischen bipolaren Platten angeordnet sind, die geeignet sind, reaktive Gattungen an die Elektroden zu führen und von der Zelle während des Betriebs erzeugte Wärme abzuleiten, wobei die bipolaren Platten eine anfängliche räumliche Dickenverteilung ($e^{PB,i}_{x,y}$) aufweisen, wobei die Zelle einen Parameter von Interesse aufweist, der für den elektrischen Kontaktwiderstand (Rc), der räumlich nach einer anfänglichen Verteilung ($Rc^i_{x,y}$) verteilt ist, repräsentativ ist;
ii) durch das Verfahren (100; 200) nach einem der vorhergehenden Ansprüche Bestimmung einer räumlichen Verteilung ($Rc^f_{x,y}$) des Parameters von Interesse (Rc);
iii) Herstellung (160; 260) der Zelle auf Basis der Referenzzelle, so dass der Parameter von Interesse (Rc) die bestimmte räumliche Verteilung ($Rc^f_{x,y}$) aufweist.

8. Verfahren zur Herstellung einer elektrochemischen Zelle nach Anspruch 7, bei dem eine räumliche Dickenverteilung ($e^{PB,f}_{x,y}$) mindestens einer der bipolaren Platten in Abhängigkeit von der bestimmten räumlichen Verteilung ($Rc^f_{x,y}$) bestimmt wird.

9. Verfahren zur Herstellung einer elektrochemischen Zelle nach Anspruch 8, bei dem die bipolare Platte lokal eine Dicke ($e^{PB,f}_{x,y}$) kleiner oder größer als eine Nominaldicke der Platte im Wesentlichen gleich der Anfangsdicke ($e^{PB,i}_{x,y}$) in vorher auf Basis der bestimmten räumlichen Verteilung ($Rc^f_{x,y}$) des elektrischen Kontaktwiderstands (Rc) identifizierten Zonen aufweist.

**10.** Verfahren zur Herstellung eines elektrochemischen Reaktors, umfassend die folgenden Schritte:

i. Betrachtung eines elektrochemischen Referenzreaktors, umfassend eine Stapelung von elektrochemischen Zellen, die zwischen zwei Endplatten eingespannt und komprimiert sind, wobei jede Zelle zwei voneinander durch ein Elektrolyt getrennte Elektroden umfasst, die zwischen bipolaren Platten angeordnet sind, die geeignet sind, reaktive Gattungen zu den Elektroden zu führen und von der Zelle während des Betriebs erzeugte Wärme abzuleiten, und umfassend einen Parameter von Interesse, der für den elektrischen Kontaktwiderstand (Rc) repräsentativ ist, der räumlich nach einer anfänglichen Verteilung ($Rc^i_{x,y}$) verteilt ist;

ii. durch das Verfahren (100; 200) nach einem der Ansprüche 1 bis 6 Bestimmung einer räumlichen Verteilung ($Rc^f_{x,y}$) des Parameters von Interesse (Rc) für mindestens eine der Zellen;

iii. Herstellung (160; 260) des elektrochemischen Reaktors auf Basis des Referenzreaktors, so dass der Parameter von Interesse (Rc) die bestimmte räumliche Verteilung ($Rc^f_{x,y}$) aufweist.

**11.** Verfahren zur Herstellung eines elektrochemischen Reaktors nach Anspruch 10, bei dem eine räumliche Dickenverteilung ($e^{70a,70b}_{x,y}$) mindestens einer der Endplatten und/oder eine räumliche Dickenverteilung ($e^{80}_{x,y}$) mindestens einer Platte, die zwischen zwei aneinandergrenzende Zellen der Stapelung eingesetzt ist, in Abhängigkeit von der bestimmten räumlichen Verteilung ($Rc^f_{x,y}$) bestimmt wird.

**12.** Aufzeichnungsträger von Informationen, umfassend Befehle für den Einsatz des Bestimmungsverfahrens nach einem der Ansprüche 1 bis 6, wobei diese Befehle geeignet sind, von einem Prozessor ausgeführt zu werden.

**Claims**

**1.** Method for determining a spatial distribution $\left(Rc^f_{x,y}\right)$ of a parameter of interest (Rc) representative of an electrical contact resistance between a bipolar plate and an adjacent electrode of an electrochemical cell, said cell including two electrodes separated from one another by an electrolyte and placed between bipolar plates suitable for bringing reactive species to the electrodes and for removing the heat produced by the cell in operation, comprising the following steps:

i) providing (110; 210) an electrochemical cell, within which the parameter of interest (Rc) is distributed with an initial spatial distribution $\left(Rc^i_{x,y}\right)$ and for which the spatial distribution of a temperature within the electrochemical cell in operation has at least one local value higher than or equal to a preset maximum local value;

ii) defining (120; 220) a spatial distribution $\left(T^c_{x,y}\right)$ of a set-point temperature ($T^c$) within the electrochemical cell in operation, said distribution being such that the local temperature values are lower than preset maximum local values;

iii) measuring (130; 230) a spatial distribution $\left(D^r_{x,y}\right)$ of a first thermal quantity representative of the local removal of heat ($D^r$) within said electrochemical cell in operation;

iv) estimating (140; 240) a spatial distribution $\left(Q^e_{x,y}\right)$ of a second thermal quantity ($Q^e$) representative of the local production of heat ($Q^e$) within said electrochemical cell in operation, depending on said spatial distribution $\left(T^c_{x,y}\right)$ of the set-point temperature ($T^c$) and on said spatial distribution $\left(D^r_{x,y}\right)$ of the first thermal quantity ($D^r$), so that the spatial distribution of the temperature of said electrochemical cell in operation, the first thermal quantity ($D^r$) of which cell having said measured spatial distribution and the second thermal quantity ($Q^e$) of which cell having said estimated spatial distribution $\left(Q^e_{x,y}\right)$, is substantially equal to that $\left(T^c_{x,y}\right)$ of the set-point temperature ($T^c$); and

v) determining (150; 250) a spatial distribution $\left(Rc^f_{x,y}\right)$ of the parameter of interest (Rc) depending on the estimated spatial distribution $\left(Q_{x,y}^{e}\right)$ of the second thermal quantity ($Q^{e}$);

and wherein the step of estimating a spatial distribution of the second thermal quantity includes:

- a phase of generating a mesh of a cooling circuit of at least one bipolar plate of the electrochemical cell, through which circuit a heat-transfer fluid is intended to flow; and
- a phase of simulating numerically by computer the second thermal quantity on said mesh, by solving a discrete numerical model expressing the second thermal quantity as a function of the local temperature and of the first thermal quantity.

2. Determining method according to Claim 1, wherein the parameter of interest is the electrical contact resistance (Rc) of the electrochemical cell, the first thermal quantity is representative of the local removal ($D^{r}$) of the heat produced by the cell in operation, and the second thermal quantity is representative of the local production of heat ($Q^{e}$) by the cell in operation.

3. Determining method according to Claim 1 or 2, wherein the bipolar plates are formed from two sheets that are bonded to each other, each sheet including embossments forming, in what is called an external face, a circuit for distributing a reactive species, the embossments of the sheets together forming, in what are called internal faces that are opposite the external faces, a cooling circuit including cooling channels that communicate fluidically with one another between an inlet and an outlet of the cooling circuit.

4. Determining method according to any one of Claims 1 to 3, wherein the step of determining the spatial distribution of the parameter of interest is furthermore carried out depending on a preset overall electrical power value of the electrochemical cell.

5. Determining method according to any one of Claims 1 to 4, wherein the first thermal quantity is the measured effective local flow rate ($D^{r}$) of a heat-transfer fluid flowing in a cooling circuit of a bipolar plate of the cell, and the second thermal quantity is the local heat flux ($Q^{e}$) produced by the cell in operation.

6. Determining method according to Claim 5, wherein step v) includes:

a) a first sub-step of estimating the spatial distribution of the density of an electrical signal (le) produced by the cell in operation, from the estimated spatial distribution of the produced heat flux ($Q^{e}$); and
b) a second sub-step of determining the spatial distribution of the parameter of interest (Rc), from the local density of the electrical signal (le).

7. Method for producing an electrochemical cell, including steps of:

i) considering a reference electrochemical cell, said cell including two electrodes separated from each other by an electrolyte and placed between bipolar plates suitable for bringing reactive species to the electrodes and for removing the heat produced by the cell in operation, the bipolar plates having an initial thickness spatial distribution $\left(e_{x,y}^{PB,i}\right)$, the cell having a parameter of interest representative of the electrical contact resistance (Rc), which parameter is spatially distributed with an initial distribution $\left(Rc_{x,y}^{i}\right)$;

ii) determining a spatial distribution $\left(Rc_{x,y}^{f}\right)$ of the parameter of interest (Rc), using the method (100; 200) according to any one of the preceding claims; and
iii) producing said cell (160; 260), from the reference cell in such a way that the parameter of interest (Rc) has the determined spatial distribution $\left(Rc_{x,y}^{f}\right)$.

8. Method for producing an electrochemical cell according to Claim 7, wherein a spatial distribution $\left(e_{x,y}^{PB,f}\right)$ of the thickness of at least one of the bipolar plates is determined depending on the determined spatial distribution $\left(Rc_{x,y}^{f}\right)$.

9. Method for producing an electrochemical cell according to Claim 8, wherein said bipolar plate locally has a thickness $\left(e_{x,y}^{PB,f}\right)$ smaller than or larger than a nominal plate thickness substantially equal to the initial thickness $\left(e_{x,y}^{PB,i}\right)$ in zones identified beforehand using said determined spatial distribution $\left(Rc_{x,y}^{f}\right)$ of the electrical contact resistance (Rc).

10. Method for producing an electrochemical reactor, including steps of:

i. considering a reference electrochemical reactor, said reactor including a stack of electrochemical cells clamped and compressed between two end plates, each cell comprising two electrodes separated from each other by an electrolyte and placed between bipolar plates suitable for bringing reactive species to the electrodes and for removing the heat produced by the cell in operation, and having a parameter of interest representative of the electrical contact resistance (Rc), which parameter is spatially distributed with an initial distribution $\left(Rc_{x,y}^{i}\right)$;

ii. determining a spatial distribution $\left(Rc_{x,y}^{f}\right)$ of the parameter of interest (Rc), for at least one of the cells using the method (100; 200) according to any one of Claims 1 to 6; and

iii. producing said electrochemical reactor (160; 260), from the reference reactor in such a way that the parameter of interest (Rc) has the determined spatial distribution $\left(Rc_{x,y}^{f}\right)$.

11. Method for producing an electrochemical reactor according to Claim 10, wherein a spatial distribution $\left(e_{x,y}^{70a,70b}\right)$ of the thickness of at least one of the end plates and/or a spatial distribution $\left(e_{x,y}^{80}\right)$ of the thickness of at least one plate inserted between two adjacent cells of said stack are/is determined depending on the determined spatial distribution $\left(Rc_{x,y}^{f}\right)$.

12. Data storage medium containing instructions for implementing the determining method according to any one of Claims 1 to 6, these instructions being executable by a processor.

**Fig.1a**

**Fig.1b**

**Fig.2**

**Fig.3**

$Rc_{x,y}^{i}$ — 210

$T_{x,y}^{c}$ — 220

— 200

$D_{x,y}^{r}$ — 230

— 201

$Q_{x,y}^{e}$ — 240

$Rc_{x,y}^{f}$ — 250

— 260

**Fig.4**

$$T^c_{i,j+1}$$
$$D^r_{i,j+1}$$
$$Q^e_{i,j+1}$$

$$d^1_{i,j}$$

$$T^c_{i-1,j} \qquad d^2_{i,j} \qquad T^c_{i,j} \qquad d^3_{i,j} \qquad T^c_{i+1,j}$$
$$D^r_{i-1,j} \qquad\qquad D^r_{i,j} \qquad\qquad D^r_{i+1,j}$$
$$Q^e_{i-1,j} \qquad\qquad Q^e_{i,j} \qquad\qquad Q^e_{i+1,j}$$

$$d^4_{i,j}$$

$$T^c_{i,j-1}$$
$$D^r_{i,j-1}$$
$$Q^e_{i,j-1}$$

y

x

**Fig.5**

**Fig.6a**

**Fig.6b**

30

**Fig.7a**

**Fig.7b**

**Fig.8**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2976732

**Littérature non-brevet citée dans la description**

- **WANG et al.** Experimental study on clamping pressure distribution in PEM fuel cells. *Journal of Power Sources,* 2008, vol. 179, 305-309
- **YU et al.** Composite endplates with pre-curvature for PEMFC (polymer electrolyte membrane fuel cell. *Composite Structures,* 2010, vol. 92, 1498-1503
- **INOUE et al.** Numerical analysis of relative humidity distribution in polymer electrolyte fuel cell stack including cooling water. *J. Power Sources,* 2006, vol. 162, 81-93
- **Z. WU ; Y. ZHOU ; G. LIN ; S. WANG ; S. J. HU.** An improved model for predicting electrical contact resistance between bipolar plate and gas diffusion layer in proton exchange membrane fuel cells. *J. Power Sources,* 15 Juillet 2008, vol. 182 (1), 265-269
- **ESCRIBANO et al.** Characterization of PEMFCs gas diffusion loyers properties. *Journal of Power Sources,* 2006, vol. 156, 8-13